# EUROPEAN PATENT APPLICATION

(11) **EP 4 852 650 A1**
(43) Date of publication of application: **09.12.2026**
(21) Application number: 26161191.7
(22) Date of filing: 27.02.2026
(51) Int. Cl.: H10D 84/01, H10D 30/01, H10D 30/00, H10D 30/63, H10D 30/68, H10D 62/10, H10D 64/27, H10D 84/83, H10D 88/00, H10D 62/80, H10D 30/67, H10B 12/00, H10D 84/03

(54) **SEMICONDUCTOR DEVICE INCLUDING UPPER AND LOWER TRANSISTORS**

(30) Priority: 04.06.2025 KR 20250073179
(71) Applicant: Samsung Electronics Co., Ltd., Suwon-si, Gyeonggi-do 16677 (KR)
(72) Inventor: LEE, Donghyeon, 16677 Suwon-si (KR); HA, Daewon, 16677 Suwon-si (KR); LEE, Hyunjae, 16677 Suwon-si (KR)
(74) Representative: Marks & Clerk LLP

(57) **Abstract**

A semiconductor device may include: a substrate; a first source/drain pattern on the substrate; a second source/drain pattern on the substrate and spaced apart from the first source/drain pattern; a first channel pattern between the first source/drain pattern and the second source/drain pattern; a first gate electrode on the first channel pattern; a second channel pattern on the first gate electrode; and a second gate electrode on the second channel pattern. The second channel pattern may include: a horizontal part that extends parallel to a top surface of the substrate; and a vertical part that extends, from the horizontal part, in a direction that crosses the top surface of the substrate.

## Description

### BACKGROUND

### 1. Field

The present disclosure relates to a semiconductor device, and more particularly, to a semiconductor device including a field effect transistor and a vertical channel transistor.

### 2. Description of Background Art

A reduction in design rule of semiconductor devices gradually accelerates a scale down of semiconductor devices. The scale down of semiconductor devices leads to a degradation in operating properties of the semiconductor devices. Accordingly, transistors with vertical channels have been suggested to increase their integration, resistance, current driving capability, and so forth. Therefore, various studies have been developed to manufacture the semiconductor device having superior performances while overcoming limitations due to high integration of the semiconductor device.

### SUMMARY

According to some embodiments of the present disclosure, a semiconductor device with improved electrical properties and increased integration may be provided.

According to some embodiments of the present disclosure, a method of fabricating a semiconductor device with improved electrical properties and increased integration may be provided.

According to some embodiments of the present disclosure, a semiconductor device may include: a substrate; a first source/drain pattern on the substrate; a second source/drain pattern on the substrate and spaced apart from the first source/drain pattern; a first channel pattern between the first source/drain pattern and the second source/drain pattern; a first gate electrode on the first channel pattern; a second channel pattern on the first gate electrode; and a second gate electrode on the second channel pattern, wherein the second channel pattern may include: a horizontal part that extends parallel to a top surface of the substrate; and a vertical part that extends, from the horizontal part, in a direction that crosses the top surface of the substrate.

According to some embodiments of the present disclosure, a semiconductor device may include: a substrate; a first source/drain pattern on the substrate; second source/drain patterns on opposite sides of the first source/drain pattern; first channel patterns between the first source/drain pattern and the second source/drain patterns; first gate electrodes on the first channel patterns; second channel patterns on the first gate electrodes; a mold pattern between the second channel patterns; and second gate electrodes on the second channel patterns, wherein the first channel patterns vertically overlap with the second channel patterns, respectively, and wherein each of the first channel patterns is connected to (e.g., directly connected to) the first source/drain pattern.

According to some embodiments of the present disclosure, a semiconductor device may include: a substrate; a lower dielectric layer on the substrate; first source/drain patterns on the lower dielectric layer; second source/drain patterns on opposite sides of at least one of the first source/drain patterns; first channel patterns between the first source/drain patterns and the second source/drain patterns; first gate electrodes on the first channel patterns; gate cutting patterns that penetrate the first gate electrodes; second channel patterns on the first gate electrodes; and second gate electrodes on the second channel patterns, wherein the first gate electrodes are in contact with the second channel patterns, respectively, wherein each of the gate cutting patterns extends in a first direction between the first source/drain patterns, and wherein each of the first gate electrodes extends in a second direction that crosses the first direction.

At least some of the above and other features of the invention are set out in the claims.

Aspects of embodiments of the present disclosure are not limited to the aspects mentioned above, and other aspects of the present disclosure, which have not been mentioned above, will be clearly understood by those skilled in the art from the following description.

### BRIEF DESCRIPTION OF DRAWINGS

FIG. 1 illustrates a circuit diagram showing a semiconductor device according to some embodiments of the present disclosure.
FIG. 2 illustrates a plan view showing a semiconductor device according to some embodiments of the present disclosure.
FIGS. 3A, 3B, and 3C illustrate cross-sectional views respectively taken along lines A-A', B-B', and C-C' of FIG. 2, showing a semiconductor device according to some embodiments of the present disclosure.
FIG. 4 illustrates an enlarged view showing a section X of FIG. 3A.
FIGS. 5A and 5B illustrate enlarged views showing a section Y of FIG. 3C.
FIGS. 6A, 6B, and 6C illustrate cross-sectional views respectively taken along lines A-A', B-B', and C-C' of FIG. 2, showing a semiconductor device according to some embodiments of the present disclosure.
FIGS. 7 to 16C illustrate diagrams showing a method of fabricating a semiconductor device according to some embodiments of the present disclosure.

### DETAILED DESCRIPTION

Some non-limiting example embodiments of the present disclosure are described below with reference to the accompanying drawings. Like reference numerals may indicate like components throughout the description.

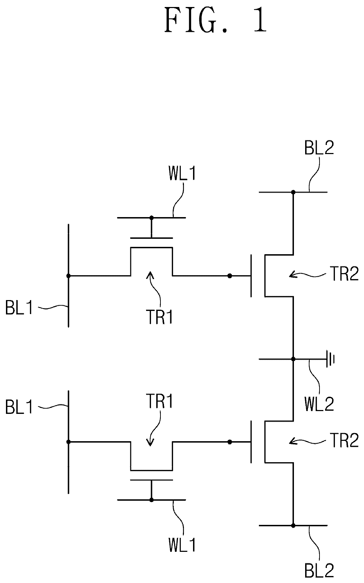

FIG. 1 illustrates a circuit diagram showing a semiconductor device according to some embodiments of the present disclosure.

Referring to FIG. 1, a semiconductor device according to some embodiments of the present disclosure may include two first transistors TR1 and two second transistors TR2. Each of the first transistors TR1 may include a first bit line BL1 and a first word line WL1. A first source/drain terminal (e.g., a source terminal) of each of the first transistors TR1 may be connected to the first bit line BL1. According to an embodiment, the first bit lines BL1 of the first transistors TR1 may be connected to each other to constitute one first bit line BL1. A gate terminal of each of the first transistors TR1 may be connected to the first word line WL1. A second source/drain terminal (e.g., a drain terminal) of each of the first transistors TR1 may be connected to a gate terminal of a corresponding one of the second transistors TR2.

The second transistors TR2 may each include a shared second word line WL2 and a second bit line BL2. The second transistors TR2 may share one source terminal, and the source terminal of the second transistors TR2 may be connected to the second word line WL2. The second word line WL2 may be grounded. For example, the second word line WL2 may be a ground line. A drain terminal of each of the second transistors TR2 may be connected to the second bit line BL2. For example, each of the first transistors TR1 may be connected to a corresponding one of the second transistors TR2, and two second transistors TR2 may share one second word line WL2.

The first bit line BL1 and the first word line WL1 may be provided with a voltage to select one of the first transistors TR1, and thus a current may flow through a drain terminal of the selected first transistor TR1. Thus, charges may be stored in a gate of the second transistor TR2 connected to the selected first transistor TR1. For example, data may be stored in the second transistors TR2 through the first transistors TR1. Afterwards, a variation in threshold voltage of the second transistor TR2 may be read through the second bit line BL2.

In such cases, each of the first transistors TR1 may correspond to a write transistor. Each of the second transistors TR2 may correspond to a read transistor. For example, each of the second transistors TR2 may have a floating gate structure where data is stored in a gate. According to an embodiment, the semiconductor device may constitute a dynamic random access memory (DRAM). According to an embodiment, the semiconductor device may constitute an embedded dynamic random access memory (eDRAM) or a dynamic random access memory (DRAM) embedded in a system on chip (SOC), a central processing unit (CPU), and/or a graphic processing unit (GPU).

Each first transistor TR1 may be either a p-channel transistor or an n-channel transistor. Each second transistor TR2 may be either a p-channel transistor or an n-channel transistor. The conductivity type of the first and second transistors TR1 and TR2 may be the same. For instance, the first and second transistors TR1 may be n-channel transistors. In the embodiment shown in FIG. 1, each second transistor TR2 is an n-channel transistor with its source terminal connected to a ground line. In alternative embodiments, each second transistor TR2 may be a p-channel transistor with its source terminal connected to a power supply line.

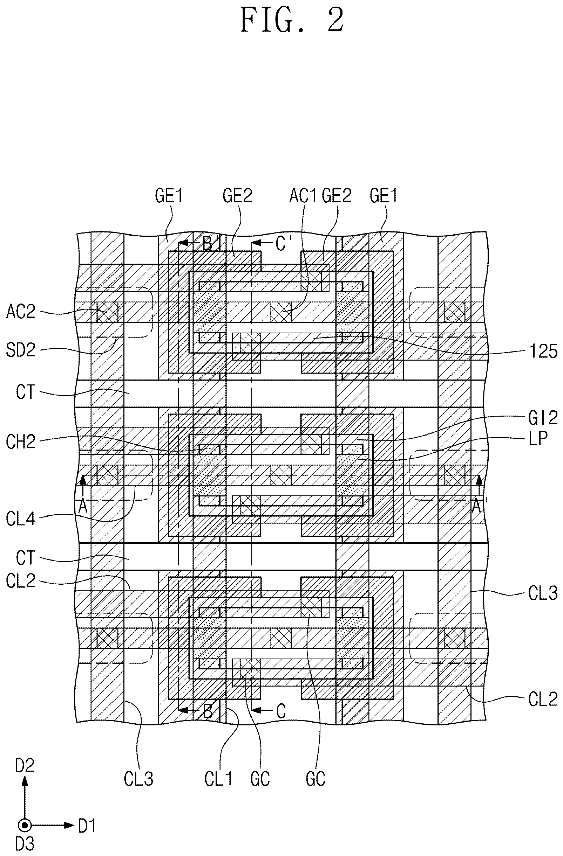

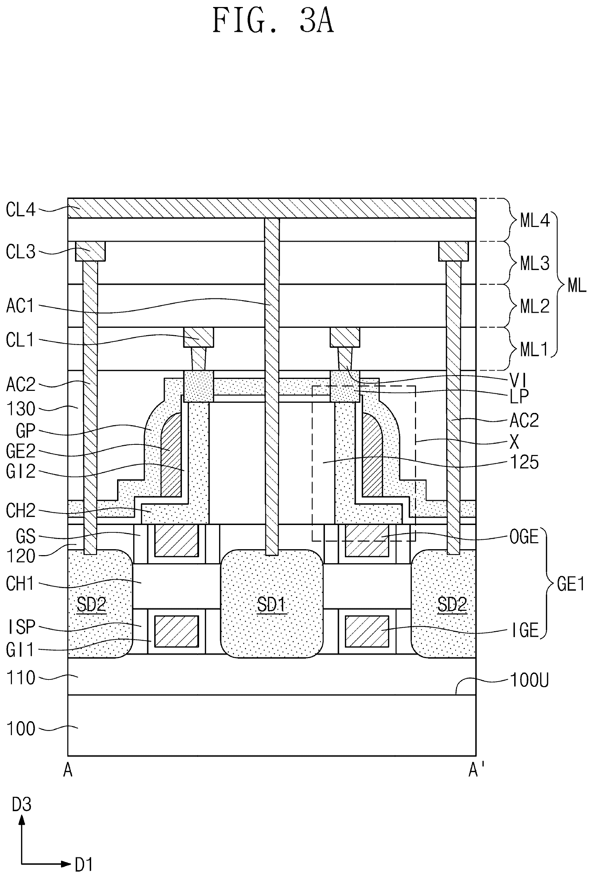

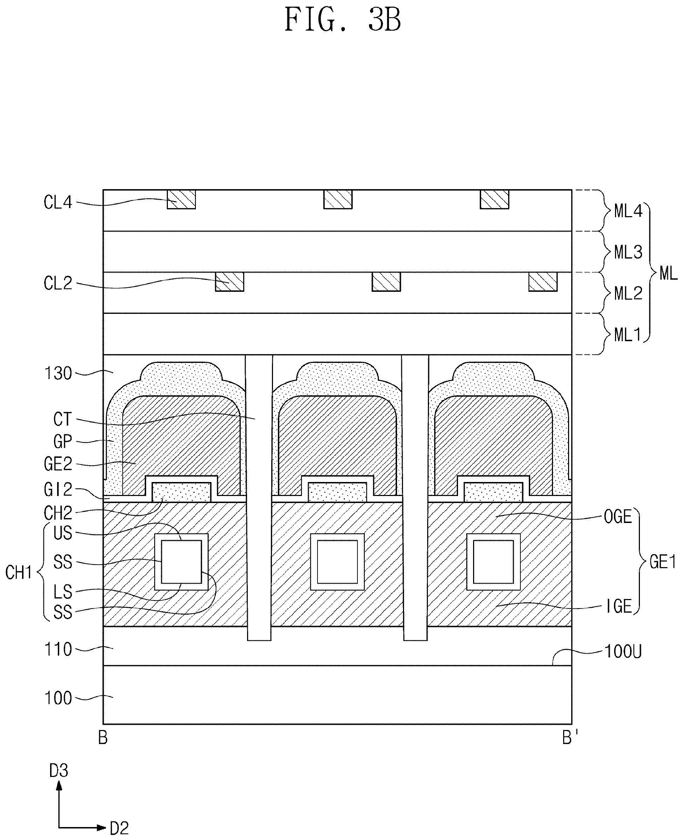

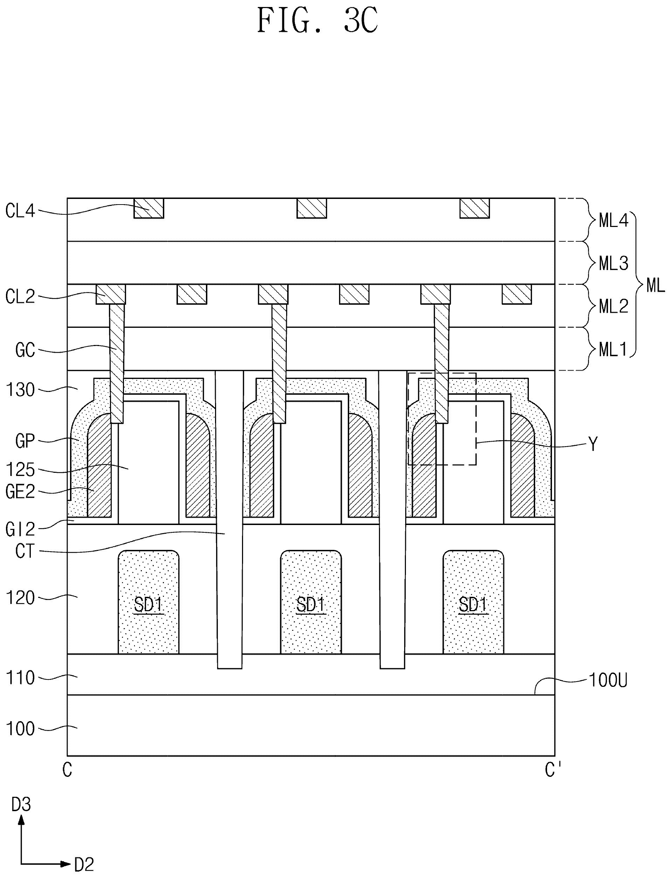

FIG. 2 illustrates a plan view showing a semiconductor device according to some embodiments of the present disclosure. FIGS. 3A, 3B, and 3C illustrate cross-sectional views respectively taken along lines A-A', B-B', and C-C' of FIG. 2, showing a semiconductor device according to some embodiments of the present disclosure.

Referring to FIGS. 2, 3A, 3B and 3C, a substrate 100 may be provided. The substrate 100 may be a compound semiconductor substrate or a semiconductor substrate including silicon, germanium, or silicon-germanium. For example, the substrate 100 may be a silicon substrate. The substrate 100 may have a top surface 100U parallel to a first direction D1 and a second direction D2. The top surface 100U may be a surface of the substrate 100 upon which transistors (e.g., the first transistors TR1 and the second transistors TR2) are located. For instance, source/drain patterns (e.g., first source/drain patterns SD1 and second source/drain patterns SD2) and channel patterns (e.g., first channel patterns CH1 and second channel patterns CH2) may be located on the top surface 100U of the substrate 100.

The first direction D1 and the second direction D2 may intersect each other. A third direction D3 may intersect the first direction D1 and the second direction D2, and may be perpendicular to the top surface 100U of the substrate 100. For example, the first direction D1, the second direction D2, and the third direction D3 may be orthogonal to each other. In this description, the first direction D1 and the second direction D2 may correspond to a horizontal direction, and the third direction D3 may correspond to a vertical direction. Relative vertical positions (e.g., upper, lower, above, below, top, bottom, etc.) may be defined with reference to the third direction D3. While the terms "horizontal", "vertical", "upper", "lower", etc. (and other similar terms) are used herein, it will be appreciated that these terms are defined relative to the structure of the device (e.g., relative to the top surface 100U of the substrate 100) and therefore need not imply any particular orientation of the device in use.

It is to be understood that when an element or layer is referred to as being "over", "above", "on", "below", "under", "beneath", "connected to" or "coupled to" another element or layer, it can be directly over, above, on, below, under, beneath, connected or coupled to the other element or layer or intervening elements or layers may be present. In contrast, when an element is referred to as being "directly over", "directly above", "directly on", "directly below", "directly under", "directly beneath", "directly connected to" or "directly coupled to" another element or layer, there are no intervening elements or layers present. A first element or layer that is formed "on" a second element or layer, may be formed on any side of the second element or layer (e.g., above, below or on a lateral surface of the second element or layer).

The term "overlap" (or "overlapping", or like terms), as may be used herein, is intended to broadly refer to a first element that intersects with at least a portion of a second element when viewed in a particular direction (e.g., in the third direction D3), but does not require that the first and second elements be completely aligned with one another. Components or layers described with reference to "overlap" in a particular direction may be at least partially obstructed by one another when viewed along a line extending in the particular direction. For instance, components or layers described with reference to "overlap" in a particular direction may be positioned such that a line that runs parallel to the particular direction may be positioned such that it intersects at least a portion of each of the components or layers. For instance, components or layers described with reference to "vertically overlap" may be at least partially obstructed by one another when viewed along a vertical direction (e.g., along a direction parallel to the third direction D3).

A lower dielectric layer 110 may be provided on the substrate 100. The lower dielectric layer 110 may have a uniform thickness covering the top surface 100U of the substrate 100. The lower dielectric layer 110 may include a dielectric material, such as one or more from among silicon oxide, silicon nitride, silicon oxynitride, and a low-k dielectric material. In this description, the low-k dielectric material may have a dielectric constant less than the dielectric constant of silicon oxide. According to an embodiment, the lower dielectric layer 110 may be formed of a plurality of stacked dielectric layers. For example, the lower dielectric layer 110 may have a multi-layered structure. An upper portion of the lower dielectric layer 110 may be partially recessed by first source/drain patterns SD1 and second source/drain patterns SD2 which will be discussed below, but embodiments of the present disclosure are not limited thereto.

The lower dielectric layer 110 may be provided thereon with first source/drain patterns SD1 and second source/drain patterns SD2. The first source/drain patterns SD1 may be source terminals of the second transistors TR2 depicted in FIG. 1, and the second source/drain patterns SD2 may be drain terminals of the second transistors TR2 depicted in FIG. 1. The first source/drain patterns SD1 and the second source/drain patterns SD2 may be spaced apart from each other along the first direction D1 and the second direction D2. For example, the first source/drain pattern SD1 may be positioned between a pair of its corresponding second source/drain patterns SD2 that are adjacent to each other in the first direction D1. When viewed in a plan view (e.g., in the third direction D3), the first source/drain patterns SD1 and the second source/drain patterns SD2 may be two-dimensionally arranged. For example, the first source/drain patterns SD1 and the second source/drain patterns SD2 may be arranged in the first direction D1 and the second direction D2.

The first source/drain patterns SD1 and the second source/drain patterns SD2 may be epitaxial patterns formed by a selective epitaxial growth (SEG) process. According to some embodiments, a top surface of each of the first source/drain patterns SD1 and the second source/drain patterns SD2 may be higher than top surfaces of first channel patterns CH1, which will be discussed below. According to some embodiments, a top surface of at least one of the first source/drain patterns SD1 and the second source/drain patterns SD2 may be substantially coplanar with the top surfaces of first channel patterns CH1, which will be discussed below.

According to an embodiment, the first source/drain patterns SD1 and the second source/drain patterns SD2 may be impurity regions each having a first conductivity type (e.g., n-type). In addition, the first source/drain patterns SD1 and the second source/drain patterns SD2 may include a semiconductor element (e.g., silicon (Si)) that is the same as a semiconductor element of the substrate 100.

According to an embodiment, the first source/drain patterns SD1 and the second source/drain patterns SD2 may be impurity regions each having a second conductivity type (e.g., p-type). The first source/drain patterns SD1 and the second source/drain patterns SD2 may include a semiconductor element (e.g., SiGe) whose lattice constant is greater than a lattice constant of a semiconductor element of the substrate 100. A compressive stress may be provided to a first channel pattern CH1 between the first source/drain pattern SD1 and the second source/drain pattern SD2 that are adjacent to each other in the first direction D1. In this case, carriers may be easily transmitted in the first channel patterns CH1 even when electrical couplings occur between first gate electrodes GE1 and second gate electrodes GE2, which will be discussed below. As a result, the semiconductor device may have improved electrical properties.

The first channel patterns CH1 may be correspondingly provided between the first source/drain patterns SD1 and the second source/drain patterns SD2, adjacent in the first direction D1 to the first source/drain patterns SD1. The first channel patterns CH1 may be channels of the second transistors TR2 depicted in FIG. 1. The first channel patterns CH1 may be spaced apart in the third direction D3 from the lower dielectric layer 110. The first channel patterns CH1 may connect the first source/drain patterns SD1 to the second source/drain patterns SD2, adjacent in the first direction D1 to the first source/drain patterns SD1. The first channel patterns CH1 may include silicon. For example, the first channel patterns CH1 may include crystalline silicon or monocrystalline silicon. According to an embodiment, the first channel patterns CH1 may be nanosheets. A nanosheet may be a pattern that has a thickness (e.g., in the third direction D3) that is in the range of 1 nm to 100 nm.

First gate electrodes GE1 may be provided on the first channel patterns CH1. The first gate electrodes GE1 may be gate terminals of the second transistors TR2 depicted in FIG. 1. The first gate electrodes GE1 may extend in the second direction D2, such as to extend across the first channel patterns CH1. The first gate electrodes GE1 may be spaced apart from each other in the first direction D1. The first gate electrodes GE1 may vertically overlap with corresponding first channel patterns CH1.

Each of the first gate electrodes GE1 may include an inner electrode IGE between the lower dielectric layer 110 and the first channel pattern CH1, and an outer electrode OGE on the first channel pattern CH1. For example, the inner electrodes IGE of the first gate electrodes GE1 may be positioned beneath the first channel patterns CH1, and the outer electrodes OGE of the first gate electrodes GE1 may be positioned above the first channel patterns CH1. In addition, the first gate electrode GE1 may be positioned on a top surface US, a bottom surface LS, and lateral surfaces SS (e.g., in the second direction D2) of the first channel pattern CH1. For example, between the first source/drain patterns SD1 and the second source/drain patterns SD2, the first gate electrodes GE1 may surround the first channel patterns CH1. For example, the first gate electrodes GE1 may surround the first channel patterns CH1 in a plane that is defined by the second direction D2 and the third direction D3.

In such cases, the first source/drain pattern SD1, the second source/drain pattern SD2, the first channel pattern CH1, and the first gate electrode GE1 may constitute a three-dimensional field effect transistor (e.g., a multi-bridge-channel field-effect transistor (MBCFET) or a gate-all-around field-effect transistor (GAAFET)) in which a gate three-dimensionally surrounds a channel. For example, the second transistor TR2 of FIG. 1 may be a three-dimensional field effect transistor.

Inner spacers ISP may be provided between the first source/drain patterns SD1 and the inner electrodes IGE of the first gate electrodes GE1 and between the second source/drain patterns SD2 and the inner electrodes IGE of the first gate electrodes GE1. The inner electrodes IGE of the first gate electrodes GE1 may be spaced apart from the first source/drain patterns SD1 across the inner spacers ISP, and may also be spaced apart from the second source/drain patterns SD2 across the inner spacers ISP. The inner spacers ISP may include a dielectric material, such as one or more from among silicon oxide, silicon nitride, silicon oxynitride, and a low-k dielectric material. The inner spacers ISP may prevent a leakage current occurring from the first gate electrodes GE1. According to an embodiment, the inner spacers ISP may be omitted.

A pair of gate spacers GS may be provided on opposite sidewalls of the outer electrode OGE of each of the first gate electrodes GE1. Each of the gate spacers GS may extend in the second direction D2 along the first gate electrode GE1. The gate spacers GS may include, for example, at least one from among SiCN, SiCON, and SiN. Alternatively, the gate spacers GS may include a multi-layer formed of two or more from among SiCN, SiCON, and SiN.

A first gate dielectric layer GI1 may be provided between the first gate electrodes GE1 and the first channel patterns CH1. The first gate dielectric layer GI1 may cover the top surface US, the bottom surface LS, and the lateral surfaces SS of each of the first channel patterns CH1. The first gate dielectric layer GI1 may cover a top surface of the lower dielectric layer 110 beneath the first gate electrodes GE1. The first gate dielectric layer GI1 may include, for example, one or more from among silicon oxide, silicon nitride, and a high-k dielectric material. Alternatively, the first gate dielectric layer GI1 may have a structure in which silicon oxide and a high-k dielectric material are stacked. In this description, the high-k dielectric material may have a dielectric constant greater than a dielectric constant of silicon oxide. According to an embodiment, the high-k dielectric material may include at least one from among hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

An interlayer dielectric layer 120 may be provided on the first source/drain patterns SD1 and the second source/drain patterns SD2. The interlayer dielectric layer 120 may extend from on the first source/drain pattern SD1 and the second source/drain pattern SD2 to the lower dielectric layer 110. For example, the interlayer dielectric layer 120 may cover the first source/drain patterns SD1, the second source/drain patterns SD2, and the lower dielectric layer 110. A top surface of the interlayer dielectric layer 120 may be substantially coplanar with top surfaces of the first gate electrodes GE1. Like the lower dielectric layer 110, the interlayer dielectric layer 120 may include a dielectric material, such as one or more from among silicon oxide, silicon nitride, silicon oxynitride, and a low-k dielectric material.

Mold patterns 125 may be provided on the interlayer dielectric layer 120. The mold patterns 125 may be positioned between the first gate electrodes GE1. The mold patterns 125 may be spaced apart from each other in the second direction D2 between the first gate electrodes GE1. The mold patterns 125 may vertically overlap with corresponding first source/drain patterns SD1. Thus, each of the mold patterns 125 may be horizontally spaced apart from the second source/drain patterns SD2 that are adjacent to each other in the first direction D1. The mold patterns 125 may include a dielectric material, such as one or more from among silicon oxide, silicon nitride, silicon oxynitride, and a low-k dielectric material.

Second channel patterns CH2 may be provided on opposite sides of each of the mold patterns 125. The second channel patterns CH2 may be source terminals, drain terminals, and channels of the first transistors TR1 depicted in FIG. 1. The second channel patterns CH2 may extend in the third direction D3 on lateral surfaces of the mold patterns 125. For example, each of the second channel patterns CH2 may be (e.g., may form or may comprise) a vertical channel that extends perpendicular to the top surface 100U of the substrate 100. The second channel patterns CH2 may further extend from on the lateral surfaces of the mold patterns 125 to and along the first gate electrodes GE1. The second channel patterns CH2 may cover the top surfaces of the first gate electrodes GE1.

The second channel patterns CH2 may include an oxide semiconductor. For example, the oxide semiconductor may include InₓGa_{y}Zn_{z}O, InₓGa_{y}Si_{z}O, InₓSn_{y}ZnzO, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, InₓGa_{y}O, or any combination thereof. Alternatively, the second channel patterns CH2 may be formed of a single layer including one oxide semiconductor or multiple layers including different oxide semiconductors. According to some embodiments, the second channel patterns CH2 may include an amorphous, crystalline, or polycrystalline oxide semiconductor. According to an embodiment, the second channel patterns CH2 may each have a bandgap energy greater than a bandgap energy of silicon. For example, the second channel patterns CH2 may each have a bandgap energy of about 1.5 eV to about 5.6 eV (e.g., of 1.5 eV to 5.6 eV), and may exhibit optimum channel performance when the bandgap energy is in a range of about 2.0 eV to about 4.0 eV (e.g., of 2.0 eV to 4.0 eV).

Second gate electrodes GE2 may be provided on the second channel patterns CH2. The second gate electrodes GE2 may be gate terminals of the first transistors TR1 depicted in FIG. 1. The second gate electrodes GE2 may be positioned on opposite sides of each of the mold patterns 125. When viewed in a plan view, the second gate electrodes GE2 may correspondingly partially surround neighboring mold patterns 125. Each of the second gate electrodes GE2 may have a bracket planar shape (e.g., a shape of a bracket in a plan view, such as, but not limited to, a squared "c" shape). Each of the second gate electrodes GE2 may have a rounded upper portion. A width in the second direction D2 of each of the second gate electrodes GE2 may be greater than a width in the second direction D2 of each of the second channel patterns CH2. Thus, the second gate electrodes GE2 may further extend onto lateral surfaces of the second channel patterns CH2, thereby being adjacent to the first gate electrodes GE1.

In such cases, the second channel pattern CH2 and the second gate electrode GE2 may constitute a vertical channel transistor (VCT) whose channel is perpendicular to the top surface 100U of the substrate 100. For example, the first transistor TR1 of FIG. 1 may be a vertical channel transistor.

A second gate dielectric layer GI2 may be provided between the second gate electrodes GE2 and the second channel patterns CH2 and between the second gate electrodes GE2 and the mold patterns 125. The second gate dielectric layer GI2 may extend to and along the interlayer dielectric layer 120 from between the second gate electrodes GE2 and the second channel patterns CH2 and from between the second gate electrodes GE2 and the mold patterns 125. The second gate dielectric layer GI2 may further extend onto top surfaces of the mold patterns 125 from between the second gate electrodes GE2 and the second channel patterns CH2 and from between the second gate electrodes GE2 and the mold patterns 125. The second gate dielectric layer GI2 may cover the top surface of the interlayer dielectric layer 120, the top surfaces of the first gate electrodes GE1, and the top surfaces of the mold patterns 125. The second gate dielectric layer GI2 may include, for example, one or more from among silicon oxide, silicon oxynitride, and a high-k dielectric material. The second gate dielectric layer GI2 may include substantially the same material as a material of the first gate dielectric layer GI1, but embodiments of the present disclosure are not limited thereto.

A capping layer GP may be provided on the second gate electrodes GE2 and the mold patterns 125. The capping layer GP may extend from the top surfaces of the mold patterns 125 onto lateral surfaces of the second gate electrodes GE2. The capping layer GP may further extend from the lateral surfaces of the second gate electrodes GE2 onto the top surface of the interlayer dielectric layer 120. The capping layer GP may include a dielectric material, such as one or more from among silicon oxide, silicon nitride, silicon oxynitride, and a low-k dielectric material, and the material of the capping layer GP may be different from a material of the interlayer dielectric layer 120.

An upper dielectric layer 130 may be provided on the capping layer GP. The upper dielectric layer 130 may cover the capping layer GP. The upper dielectric layer 130 may fill a space between the second gate electrodes GE2. The upper dielectric layer 130 may have a top surface parallel to the first direction D1 and the second direction D2. The upper dielectric layer 130 may include substantially the same material as a material of the interlayer dielectric layer 120 and/or a material of the lower dielectric layer 110.

Landing pads LP may be provided on the second channel patterns CH2. The landing pads LP may vertically overlap with corresponding second channel patterns CH2. The landing pads LP may penetrate the upper dielectric layer 130 and the capping layer GP to thereby contact the second channel patterns CH2. When viewed in a plan view, each of the landing pads LP may have a circular shape (e.g., a circular cross section in plan view), but embodiments of the present disclosure are not limited thereto. The landing pads LP may include, for example, doped polysilicon, metal, conductive metal nitride, conductive metal silicide, conductive metal oxide, or any combination thereof.

Gate cutting patterns CT may be provided in the upper dielectric layer 130. The gate cutting patterns CT may extend in the first direction D1 and may be spaced apart from each other in the second direction D2. The gate cutting patterns CT may extend from the top surface of the upper dielectric layer 130 onto an upper portion of the lower dielectric layer 110. For example, the gate cutting patterns CT may penetrate the upper dielectric layer 130, the capping layer GP, the interlayer dielectric layer 120, and the first gate electrodes GE1. Therefore, the first gate electrodes GE1 may be electrically separated from each other along the second direction D2. The gate cutting patterns CT may at least partially penetrate the upper portion of the lower dielectric layer 110.

Metal layers ML may be provided on the upper dielectric layer 130. For example, the metal layers ML may include a first metal layer ML1, a second metal layer ML2, a third metal layer ML3, and a fourth metal layer ML4 that are stacked in the third direction D3. Each of the first metal layer ML1, the second metal layer ML2, the third metal layer ML3, and the fourth metal layer ML4 may include a dielectric layer and wiring lines including a conductive material. The metal layers ML may be otherwise known as wiring layers.

The first metal layer ML1 may include first wiring lines CL1 and vias VI beneath the first wiring lines CL1. Each of the first wiring lines CL1 may be a first bit line BL1 as described with reference to FIG. 1. The first wiring lines CL1 may extend in the second direction D2 and may be spaced apart from each other in the first direction D1. The via VI may reside between and connect to each of the first wiring line CL1 and the landing pad LP that corresponds to the via VI.

The second metal layer ML2 may include second wiring lines CL2 and gate contacts GC beneath the second wiring lines CL2. Each of the second wiring lines CL2 may be a first word line WL1 as described with reference to FIG. 1. The second wiring lines CL2 may extend in the first direction D1 and may be spaced apart from each other in the second direction D2. The gate contacts GC may extend into the first metal layer ML1 (e.g., into the dielectric layer of the first metal layer ML1), and may be in contact with and connected to corresponding second gate electrodes GE2. For example, the gate contacts GC may penetrate the upper dielectric layer 130, the capping layer GP, and the second dielectric layer GI2. In addition, the gate contacts GC may penetrate the mold patterns 125.

The third metal layer ML3 may include third wiring lines CL3 and second active contacts AC2 beneath the third wiring lines CL3. Each of the third wiring lines CL3 may be a second bit line BL2 as described with reference to FIG. 1. The third wiring lines CL3 may extend in the second direction D2 and may be spaced apart from each other in the first direction D1. The second active contacts AC2 may extend into the first metal layer ML1 (e.g., into the dielectric layer of the first metal layer ML1) and the second metal layer ML2 (e.g., into the dielectric layer of the second metal layer ML2), and may be in contact with and connected to corresponding second source/drain patterns SD2. For example, the second active contacts AC2 may penetrate the upper dielectric layer 130, the capping layer GP, and the interlayer dielectric layer 120.

The fourth metal layer ML4 may include fourth wiring lines CL4 and first active contacts AC1 beneath the fourth wiring lines CL4. Each of the fourth wiring lines CL4 may be a second word line WL2 as described with reference to FIG. 1. The fourth wiring lines CL4 may extend in the first direction D1 and may be spaced apart from each other in the second direction D2. The first active contacts AC1 may extend into the first metal layer ML1 (e.g., into the dielectric layer of the first metal layer ML1), the second metal layer ML2 (e.g., into the dielectric layer of the second metal layer ML2), and the third metal layer ML3 (e.g., into the dielectric layer of the third metal layer ML3), and may be in contact with and connected to corresponding first source/drain patterns SD1. For example, the first active contacts AC1 may penetrate the upper dielectric layer 130, the capping layer GP, the mold patterns 125, and the interlayer dielectric layer 120.

According to some embodiments of the present disclosure, the first wiring lines CL1, the second wiring lines CL2, the third wiring lines CL3, and the fourth wiring lines CL4 may be formed only on the top surface 100U of the substrate 100. Therefore, it may be easy to design and manufacture the metal layers ML including the first wiring lines CL1, the second wiring lines CL2, the third wiring lines CL3, and the fourth wiring lines CL4.

According to some embodiments of the present disclosure, the first channel patterns CH1 may be provided thereon with the second channel patterns CH2 including a material that is relatively vulnerable to heat. Therefore, the second channel patterns CH2 may be prevented from degradation caused by a subsequent process.

According to some embodiments of the present disclosure, there may be formed a three-dimensional field effect transistor located at a lower position and a vertical channel transistor located at an upper position. The three-dimensional field effect transistor and the vertical channel transistor may be electrically connected to each other to constitute a semiconductor device. For example, the vertical channel transistor may be used as a write transistor to minimize a leakage current, and the three-dimensional field effect transistor may be used as a read transistor to increase a data retention time. Accordingly, the semiconductor device may have increased integration and improved electrical properties.

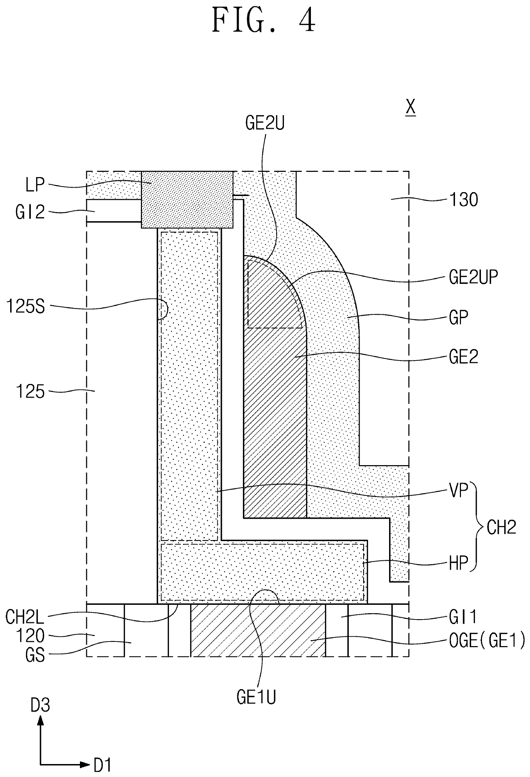

FIG. 4 illustrates an enlarged view showing a section X of FIG. 3A.

For convenience of description, repeated descriptions of features discussed with reference to FIGS. 2 and 3A to 3C may be omitted, and differences will be explained in detail below.

Referring to FIG. 4, the second channel pattern CH2 may be positioned on a top surface GE1U of the first gate electrode GE1 and a lateral surface 125S of the mold pattern 125. The second channel pattern CH2 may include a horizontal part HP (or horizontal portion) and a vertical part VP (or vertical portion) that extends from the horizontal part HP. One lateral surface of the horizontal part HP and one lateral surface of the vertical part VP may be aligned (e.g., coplanar) with each other. For example, the one lateral surface of the horizontal part HP and the one lateral surface of the vertical part VP may be aligned (e.g., coplanar) with each other along the lateral surface 125S of the mold pattern 125. The second channel pattern CH2 may have, for example, an L-shaped cross-section. At least a portion of the horizontal part HP adjacent to the first gate electrode GE1 may be a first source/drain terminal (e.g., a drain terminal) of the first transistor TR1 depicted in FIG. 1. At least a portion of the vertical part VP adjacent to the landing pad LP may be a second source/drain terminal (e.g., a source terminal) of the first transistor TR1 depicted in FIG. 1. Remaining portions of the horizontal and vertical parts HP and VP may be a channel of the first transistor TR1 depicted in FIG. 1.

The horizontal part HP of the second channel pattern CH2 may extend in the first direction D1 on the top surface GE1U of the first gate electrode GE1. For example, the horizontal part HP may extend parallel to the top surface 100U of the substrate 100 discussed with reference to FIGS. 3A to 3C. The horizontal part HP may cover and contact the top surface GE1U of the first gate electrode GE1 (e.g., a top surface of the outer electrode OGE). A bottom surface CH2L of the second channel pattern CH2 (e.g., a bottom surface of the horizontal part HP) may be substantially coplanar with the top surface GE1U of the first gate electrode GE1. Therefore, an increase in contact area may be achieved between the top surface GE1U of the first gate electrode GE1 and the bottom surface CH2L of the second channel pattern CH2. Accordingly, there may be a reduction in contact resistance between the second channel pattern CH2 and the first gate electrode GE1.

According to an embodiment, the horizontal part HP may further extend onto the first gate dielectric layer GI1 and the gate spacers GS that are positioned on opposite sides of the outer electrode OGE of the first gate electrode GE1. The horizontal part HP may be in partial contact with the first gate dielectric layer GI1 and the gate spacers GS.

The vertical part VP of the second channel pattern CH2 may extend in the third direction D3 on the lateral surface 125S of the mold pattern 125. For example, the vertical part VP may extend perpendicular to the top surface 100U of the substrate 100 discussed with reference to FIGS. 3A to 3C. The vertical part VP may cover and contact the lateral surface 125S of the mold pattern 125. Therefore, an increase in horizontal overlapping region may be achieved between the second channel pattern CH2 and the second gate electrode GE2. Accordingly, there may an increase in gate controllability of the second gate electrode GE2.

The second gate electrode GE2 may be positioned on a lateral surface of the vertical part VP of the second channel pattern CH2 and on the horizontal part HP of the second channel pattern CH2. The vertical part VP of the second channel pattern CH2 may be positioned between the second gate electrode GE2 and the mold layer 125. On the horizontal part HP, the second gate electrode GE2 may extend in the third direction D3 along the vertical part VP. According to an embodiment, the second gate electrode GE2 may have a rounded upper portion GE2UP. Thus, the second gate electrode GE2 may have a curved top surface GE2U. In addition, the second gate electrode GE2 may further extend onto the horizontal part HP.

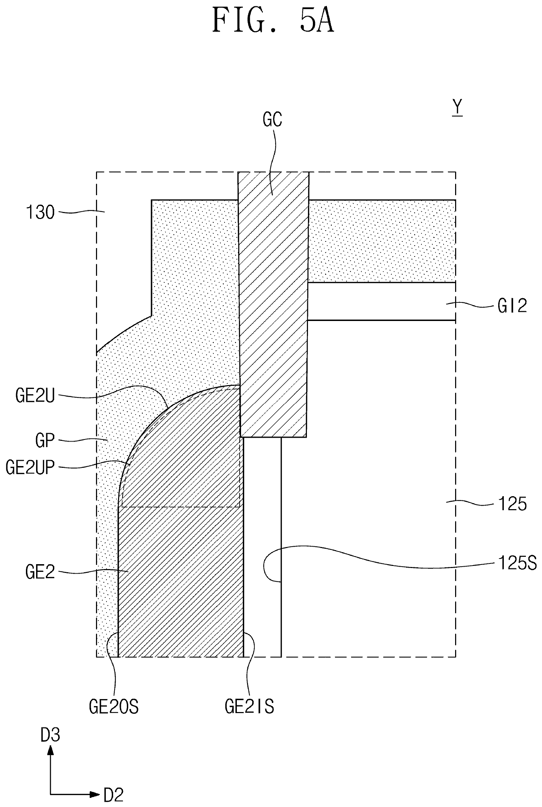

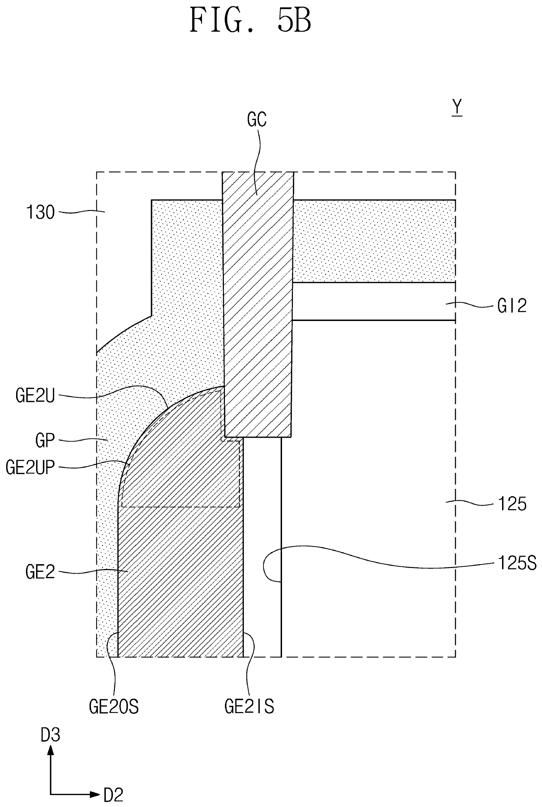

FIGS. 5A and 5B illustrate enlarged views showing a section Y of FIG. 3C.

For convenience of description, repeated descriptions of features discussed with reference to FIGS. 2 and 3A to 3C may be omitted, and differences will be explained in detail below.

Referring to FIGS. 5A and 5B, the second gate electrode GE2 may be positioned on a lateral surface 125S of the mold pattern 125. The second gate electrode GE2 may have an inner lateral surface GE2IS and an outer lateral surface GE2OS that are opposite to each other in the second direction D2. The inner lateral surface GE2IS of the second gate electrode GE2 may be in contact with the second gate dielectric layer GI2 between the second gate electrode GE2 and the mold pattern 125. The outer lateral surface GE2OS of the second gate electrode GE2 may be in contact with the capping layer GP that covers the second gate electrode GE2. In addition, the second gate electrode GE2 may have a rounded upper portion GE2UP and a curved top surface GE2U.

The gate contact GC may penetrate the upper dielectric layer 130, the capping layer GP, the second gate dielectric layer GI2, and the mold pattern 125, thereby contacting the second gate electrode GE2. The gate contact GC may connect the second gate electrode GE2 to the second wiring line CL2 discussed with reference to FIGS. 3A to 3C. A voltage may be applied through the gate contact GC to the second gate electrode GE2.

According to an embodiment, the gate contact GC may be in contact with a lateral surface of the second gate electrode GE2. For example, the gate contact GC may be in contact with the inner lateral surface GE2IS of the second gate electrode GE2. Alternatively, the gate contact GC may be in contact with the outer lateral surface GE2OS of the second gate electrode GE2. In this case, the gate contact GC and the second gate electrode GE2 may not vertically overlap with each other.

According to an embodiment, the gate contact GC may partially extend into the upper portion GE2UP of the second gate electrode GE2. The upper portion GE2UP of the second gate electrode GE2 may include a recess caused by the gate contact GC. The recess may be adjacent to the inner lateral surface GE2IS of the second gate electrode GE2, but embodiments of the present disclosure are not limited thereto. In this case, the gate contact GC and a portion of the second gate electrode GE2 may vertically overlap with each other.

According to an embodiment, the gate contact GC may extend into the upper portion GE2UP of the second gate electrode GE2. The gate contact GC may cover the upper portion GE2UP and the top surface GE2U of the second gate electrode GE2. In this case, the gate contact GC and the second gate electrode GE2 may vertically overlap with each other.

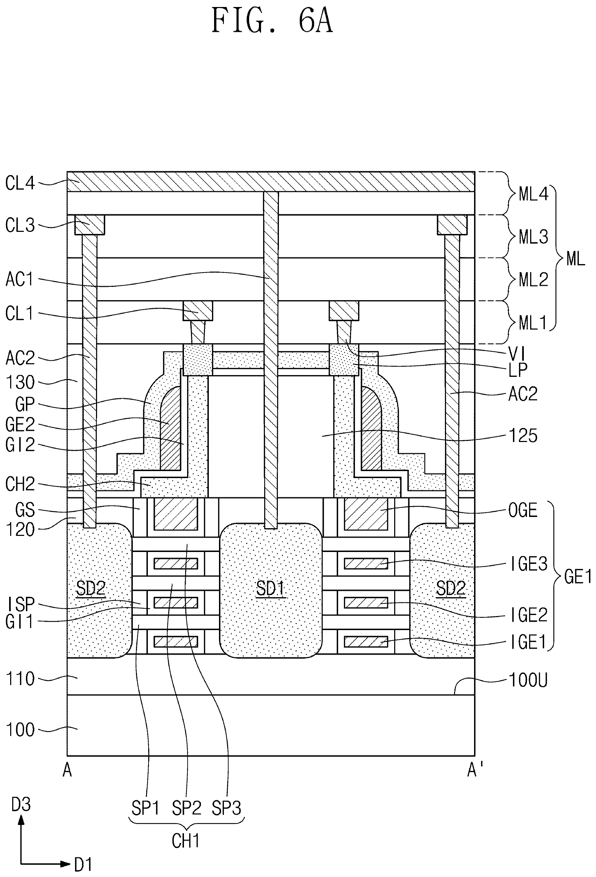

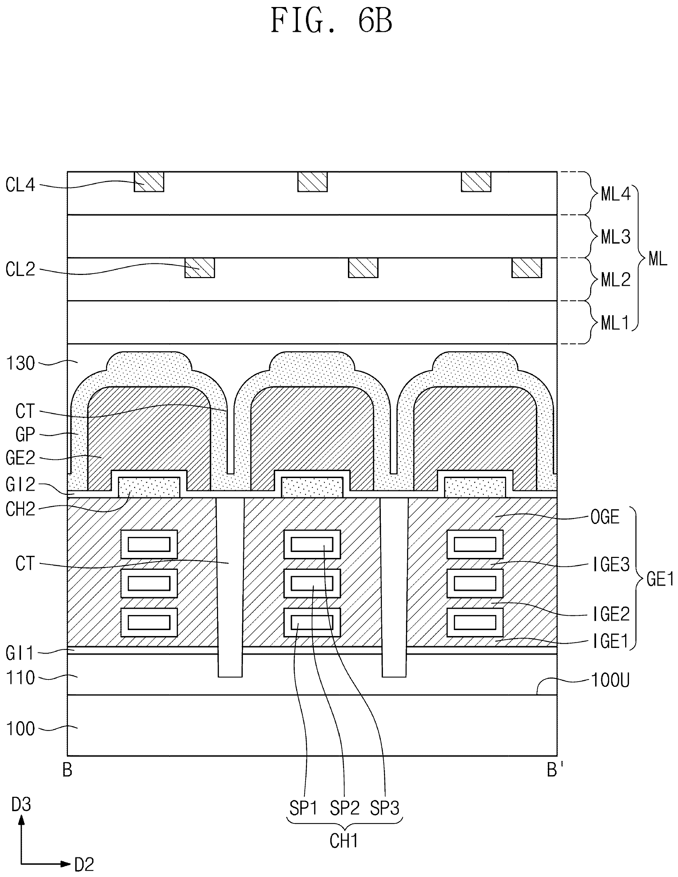

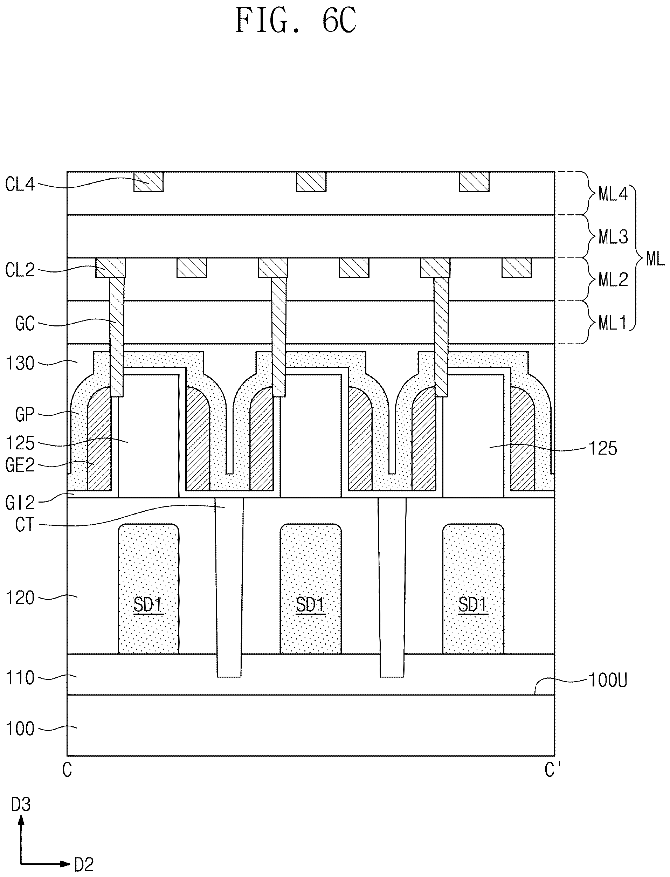

FIGS. 6A, 6B, and 6C illustrate cross-sectional views respectively taken along lines A-A', B-B', and C-C' of FIG. 2, showing a semiconductor device according to some embodiments of the present disclosure.

For convenience of description, repeated descriptions of features discussed with reference to FIGS. 2 and 3A to 3C may be omitted, and differences will be explained in detail below.

Referring to FIGS. 6A, 6B, and 6C, each of the first channel patterns CH1 between the first source/drain patterns SD1 and the second source/drain patterns SD2 may include a plurality of semiconductor patterns. For instance, each of the first channel patterns CH1 may comprise a first semiconductor pattern SP1, a second semiconductor pattern SP2, and a third semiconductor pattern SP3. The first semiconductor pattern SP1, the second semiconductor pattern SP2, and the third semiconductor pattern SP3 may electrically connect to each other the first source/drain pattern SD1 and the second source/drain pattern SD2 that are adjacent to each other in the first direction D1.

The first semiconductor pattern SP1, the second semiconductor pattern SP2, and the third semiconductor pattern SP3 of each of the first channel patterns CH1 may be spaced apart from each other in the third direction D3. Moreover, the first semiconductor pattern SP1, the second semiconductor pattern SP2, and the third semiconductor pattern SP3 of each of the first channel patterns CH1 may vertically overlap with each other. For example, the first semiconductor pattern SP1, the second semiconductor pattern SP2, and the third semiconductor pattern SP3 of each of the first channel patterns CH1 may be spaced apart from and stacked on each other.

Each of the first semiconductor pattern SP1, the second semiconductor pattern SP2, and the third semiconductor pattern SP3 may include silicon. For example, each of the first semiconductor pattern SP1, the second semiconductor pattern SP2, and the third semiconductor pattern SP3 may include crystalline silicon or monocrystalline silicon. For another example, each of the first semiconductor pattern SP1, the second semiconductor pattern SP2, and the third semiconductor pattern SP3 may be nanosheets.

Each of the first gate electrodes GE1 on the first channel patterns CH1 may include a first inner electrode IGE1, a second inner electrode IGE2, a third inner electrode IGE3, and an outer electrode OGE. The first inner electrode IGE1 may be positioned between the lower dielectric layer 110 and the first semiconductor pattern SP1. The second inner electrode IGE2 may be positioned between the first semiconductor pattern SP1 and the second semiconductor pattern SP2. The third inner electrode IGE3 may be positioned between the second semiconductor pattern SP2 and the third semiconductor pattern SP3. The outer electrode OGE may be positioned on the third semiconductor pattern SP3.

Between the first source/drain pattern SD1 and the second source/drain pattern SD2, the first gate electrode GE1 may surround the first semiconductor pattern SP1, the second semiconductor pattern SP2, and the third semiconductor pattern SP3 of the first channel pattern CH1. For example, the first gate electrode GE1 may be positioned on a top surface, a bottom surface, and lateral surfaces (e.g., in the second direction D2) of each of the first semiconductor pattern SP1, the second semiconductor pattern SP2, and the third semiconductor pattern SP3.

The first gate dielectric layer GI1 may be positioned between the first gate electrodes GE1 and the first channel patterns CH1. The first gate dielectric layer GI1 may cover the top surface, the bottom surface, and the lateral surfaces (e.g., in the second direction D2) of each of the first semiconductor pattern SP1, the second semiconductor pattern SP2, and the third semiconductor pattern SP3. For example, the first gate dielectric layer GI1 may surround each of the first semiconductor pattern SP1, the second semiconductor pattern SP2, and the third semiconductor pattern SP3.

The gate cutting patterns CT may be positioned in the first gate electrodes GE1 and the interlayer dielectric layer 120. The gate cutting patterns CT may extend into the lower dielectric layer 110 from top surfaces of the first gate electrodes GE1 and a top surface of the interlayer dielectric layer 120. For example, the gate cutting patterns CT may be positioned beneath the second channel patterns CH2, the second gate dielectric layer GI2, the second gate electrodes GE2, the mold patterns 125, the capping layer GP, and the upper dielectric layer 130.

While the embodiments of FIG. 6A and 6B include first channels CH1 having three semiconductor patterns SP1, SP2, and SP3, and first gate electrodes GE1 that include three inner gate electrodes IGE1, IGE2 and IGE3, the disclosure is not limited therefore. Accordingly, each of the first channels CH1 may include any number of semiconductor patterns and each first gate electrode GE1 may include any number of inner gate electrodes. For instance, a lowermost inner gate electrode may be provided between the lowermost semiconductor pattern and the lower dielectric layer 110, and a corresponding inner gate electrode may be provided between each adjacent pair of semiconductor patterns in the first gate electrode GE1.

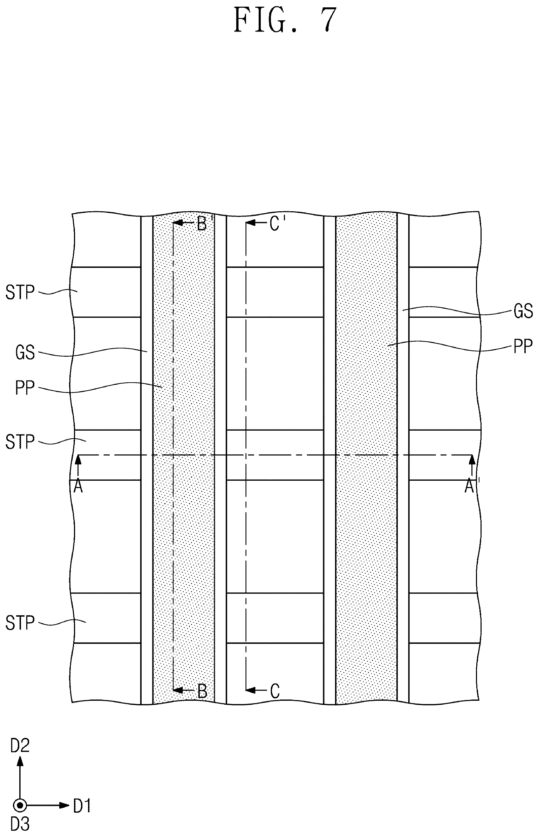

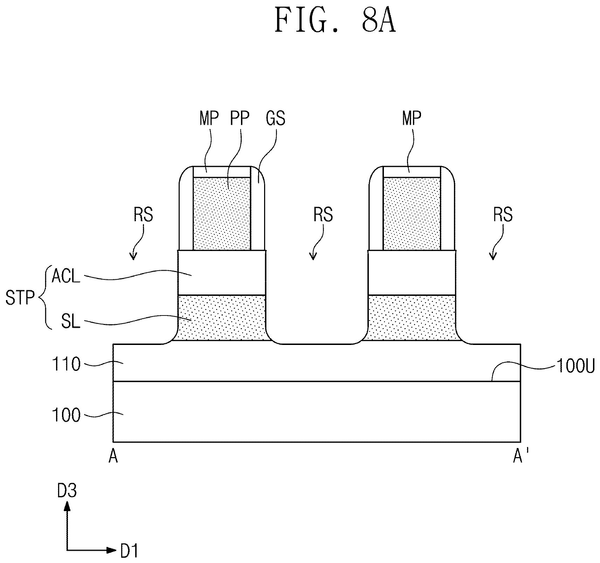

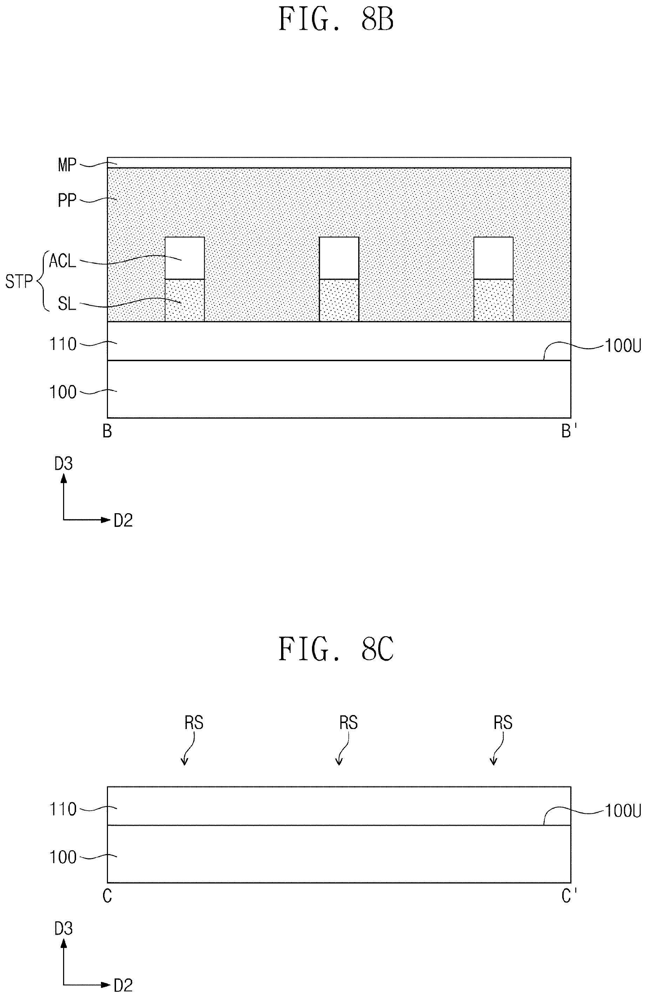

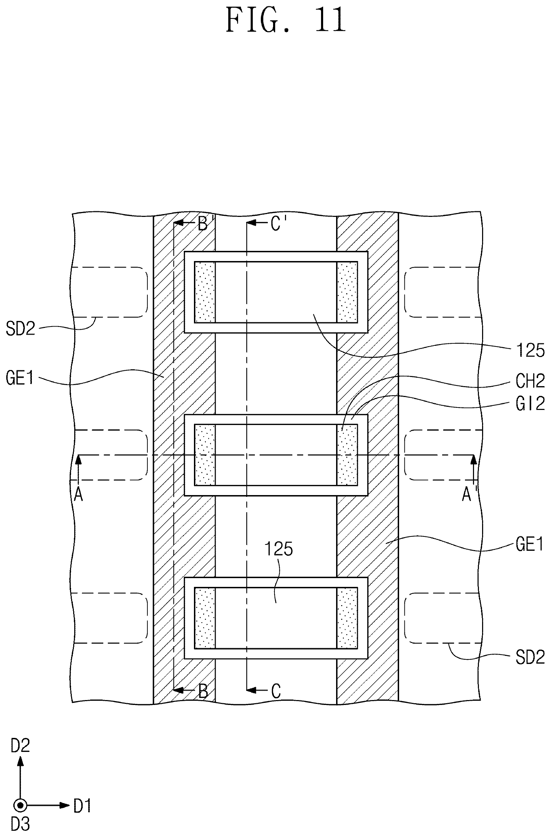

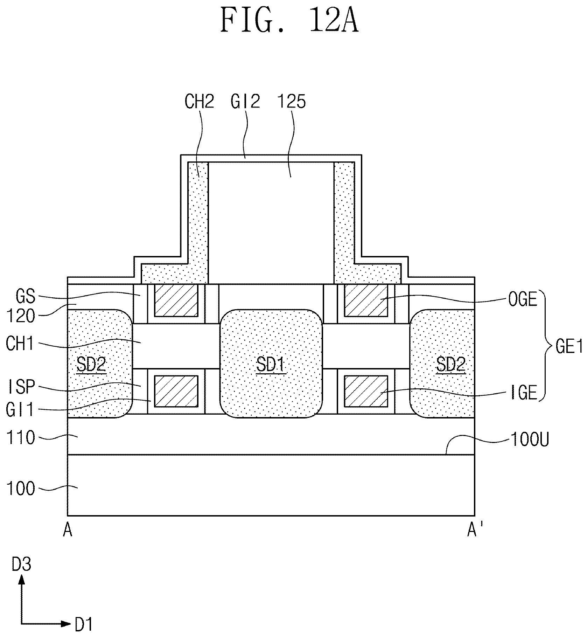

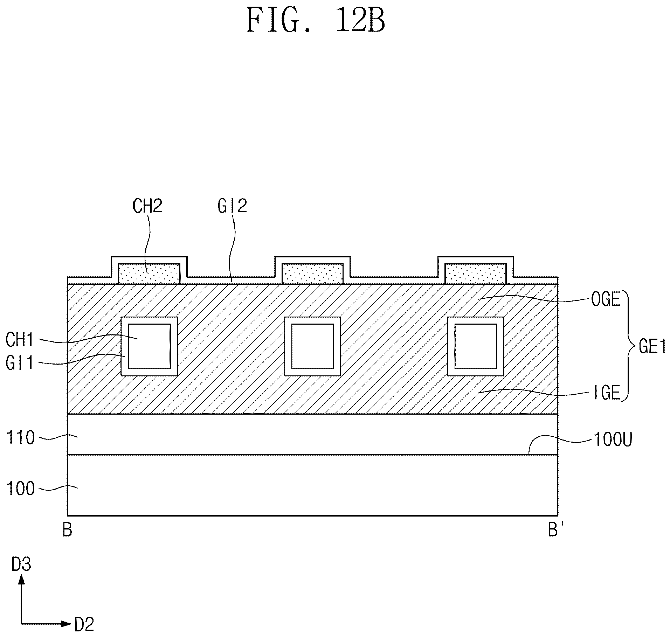

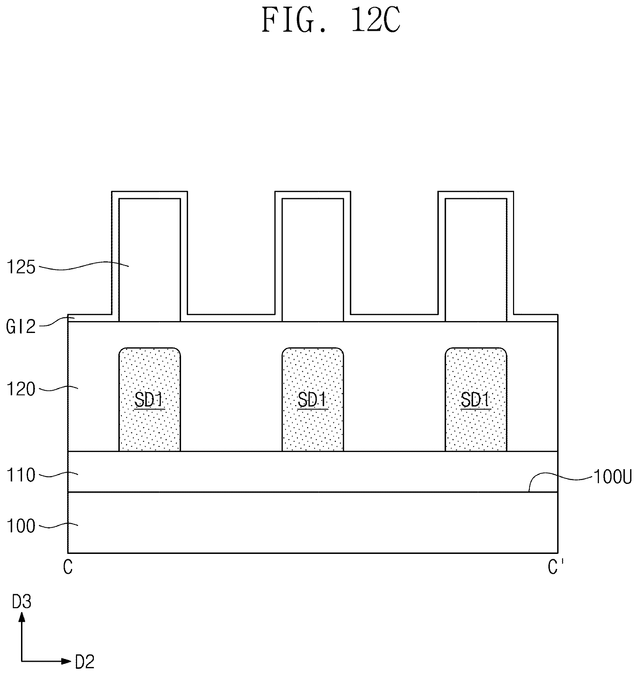

FIGS. 7 to 16C illustrate diagrams showing a method of fabricating a semiconductor device according to some embodiments of the present disclosure. FIGS. 7, 9, 11, 13, and 15 illustrate plan views showing a semiconductor device. FIGS. 8A, 10A, 12A, 14A, and 16A illustrate cross-sectional views taken along a line A-A' of FIGS. 7, 9, 11, 13, and 15, respectively. FIGS. 8B, 10B, 12B, 14B, and 16B illustrate cross-sectional views taken along a line B-B' of FIGS. 7, 9, 11, 13, and 15, respectively. FIGS. 8C, 10C, 12C, 14C, and 16C illustrate cross-sectional views taken along a line C-C' of FIGS. 7, 9, 11, 13, and 15, respectively.

Referring to FIGS. 7, 8A, 8B, and 8C, a substrate 100 may be provided, the substrate 100 having a top surface 100U that is parallel to a first direction D1 and a second direction D2. A lower dielectric layer 110 may be formed on the substrate 100. For example, the lower dielectric layer 110 on the substrate 100 may be formed by a deposition process or an oxidation process.

A sacrificial layer SL may be formed on the lower dielectric layer 110, and an active layer ACL may be formed on the sacrificial layer SL. The sacrificial layer SL may include a material having an etch selectivity with respect to the active layer ACL. For example, the active layer ACL may include one from among silicon, germanium, and silicon-germanium, and the sacrificial layer SL may include another from among silicon, germanium, and silicon-germanium. According to an embodiment, the active layer ACL may include silicon, and the sacrificial layer SL may include silicon-germanium. In this case, the sacrificial layer SL may have a germanium concentration of about 10 at% to about 30 at% (e.g., 10 at% to 30 at%).

Afterwards, stack patterns STP may be formed, each of which includes the sacrificial layer SL and the active layer ACL. For example, the stack patterns STP may be formed by patterning the sacrificial layer SL and the active layer ACL on the lower dielectric layer 110. The stack patterns STP may extend in the first direction D1 and may be spaced apart from each other in the second direction D2. In this case, the lower dielectric layer 110 may serve as an etch stop layer.

On the substrate 100, sacrificial patterns PP may be formed to extend across the stack patterns STP. The formation of the sacrificial patterns PP may include forming a sacrificial layer on the top surface 100U of the substrate 100, forming hardmask patterns MP on the sacrificial layer, and using the hardmask patterns MP as an etching mask to etch the sacrificial layer. Each of the sacrificial patterns PP may be formed to have a linear or bar shape that extends in the second direction D2. The sacrificial patterns PP may be spaced apart from each other in the first direction D1. The sacrificial layer may include, for example, polysilicon.

A pair of gate spacers GS may be formed on opposite sidewalls of each of the sacrificial patterns PP. The formation of the gate spacers GS may include forming a gate spacer layer having a uniform thickness on the top surface 100U of the substrate 100 and anisotropically etching the gate spacer layer. The gate spacers GS may be formed of multiple layers.

Recesses RS may be formed in the stack patterns STP. The formation of the recesses RS may include removing portions of the stack patterns STP by an etching process in which the hardmask patterns MP and the gate spacers GS are used as an etching mask. Each of the recesses RS may be formed between a pair of sacrificial patterns PP. The recesses RS may expose the sacrificial layer SL and the active layer ACL of each of the stack patterns STP.

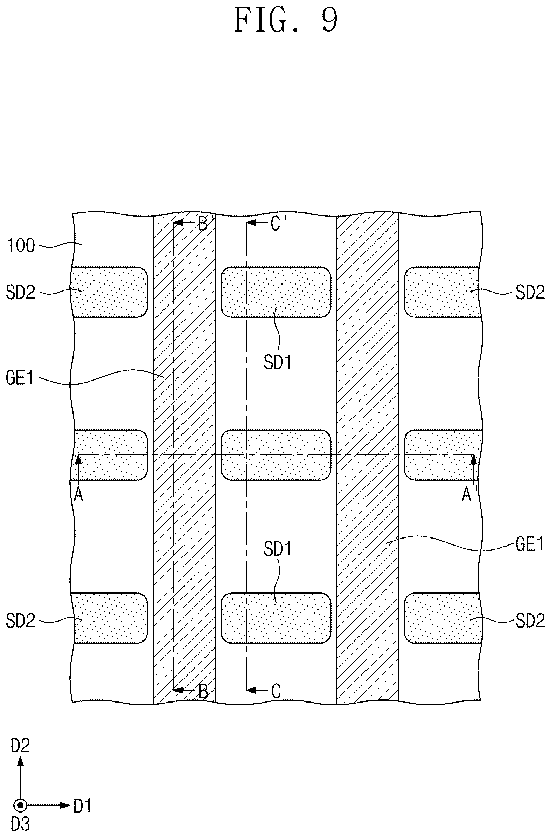

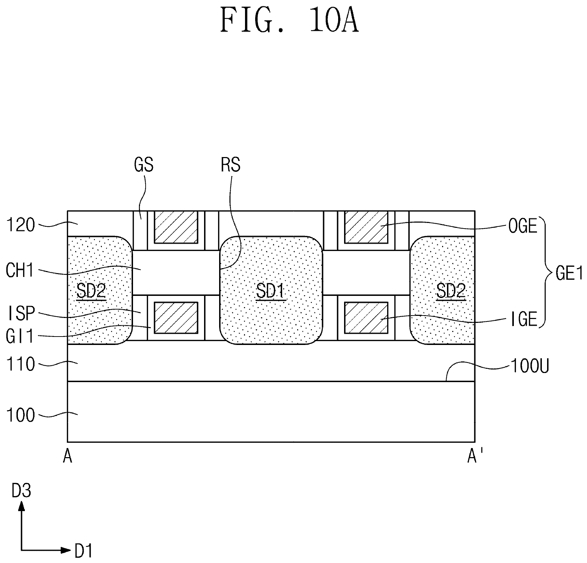

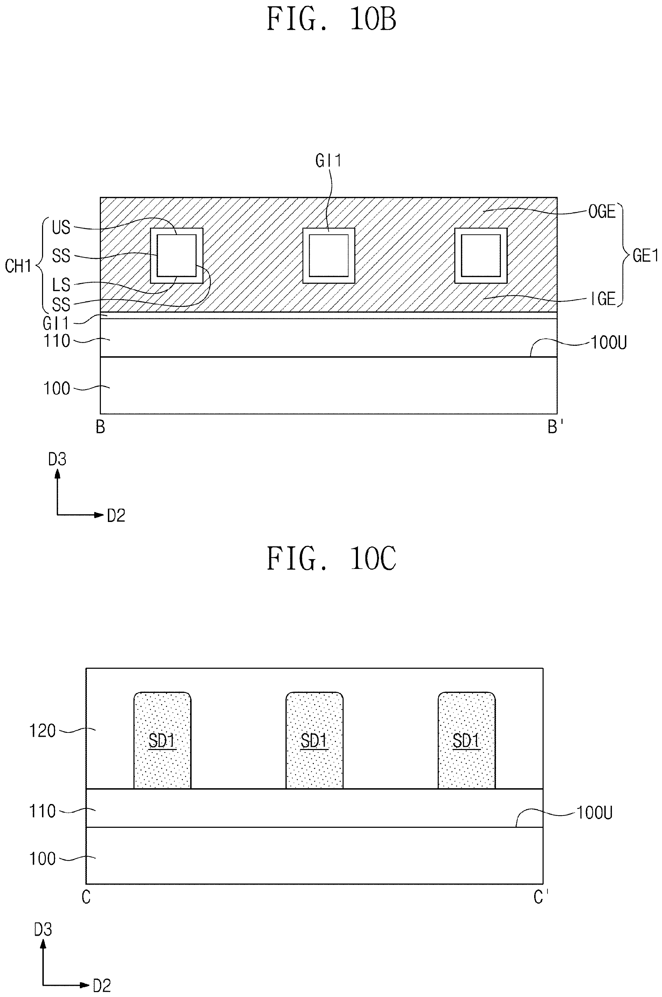

Referring to FIGS. 9, 10A, 10B, and 10C, a selective etching process may be performed on the exposed sacrificial layer SL. The selective etching process may include a wet etching process that selectively removes silicon-germanium. The selective etching process may cause that lateral surfaces of the sacrificial layer SL to be partially removed and indented. Inner spacers ISP may be formed on the indented lateral surfaces of the sacrificial layer SL.

First source/drain patterns SD1 and second source/drain patterns SD2 may be formed in the recesses RS. The first source/drain patterns SD1 and the second source/drain patterns SD2 may be formed by a selective epitaxial growth (SEG) process in which inner sidewalls of the recesses RS are used as seed layers. The first source/drain patterns SD1 and the second source/drain patterns SD2 may be grown from a seed or the active layer ACL that is exposed through the recesses RS. The SEG process may include, for example, chemical vapor deposition (CVD) and/or molecular beam epitaxy (MBE).

According to an embodiment, the first source/drain patterns SD1 and the second source/drain patterns SD2 may include a semiconductor element (e.g., Si) the same as a semiconductor element of the substrate 100. For example, during the formation of the first source/drain patterns SD1 and the second source/drain patterns SD2, impurities (e.g., phosphorus, arsenic, or antimony) may be in-situ implanted to allow the first source/drain patterns SD1 and the second source/drain patterns SD2 to have a first conductivity type (e.g., n-type). Alternatively, after the formation of the first source/drain patterns SD1 and the second source/drain patterns SD2, impurities may be implanted into the first source/drain patterns SD1 and the second source/drain patterns SD2.

According to an embodiment, the first source/drain patterns SD1 and the second source/drain patterns SD2 may include a semiconductor element (e.g., SiGe) whose lattice constant is greater than a lattice constant of a semiconductor element of the substrate 100. For example, during the formation of the first source/drain patterns SD1 and the second source/drain patterns SD2, impurities (e.g., boron, gallium, or indium) may be in-situ implanted to allow the first and second source/drain patterns SD1 and SD2 to have a second conductivity type (e.g., p-type). Alternatively, after the formation of the first source/drain patterns SD1 and the second source/drain patterns SD2, impurities may be implanted into the first source/drain patterns SD1 and the second source/drain patterns SD2.

Thereafter, an interlayer dielectric layer 120 may be formed to cover the first source/drain patterns SD1, the second source/drain patterns SD2, the hardmask patterns MP, and the gate spacers GS. The interlayer dielectric layer 120 may be in contact with the lower dielectric layer 110.

A planarization process may be performed on the interlayer dielectric layer 120. The planarization process on the interlayer dielectric layer 120 may continue until top surfaces of the sacrificial patterns PP are exposed. The planarization process may remove the hardmask patterns MP. The interlayer dielectric layer 120, the sacrificial patterns PP, and the gate spacers GS may have their top surfaces that are substantially coplanar with each other. Therefore, the sacrificial patterns PP may be externally exposed.

The exposed sacrificial patterns PP may be selectively removed. The removal of the sacrificial patterns PP may externally expose the sacrificial layer SL. The exposed sacrificial layer SL may also be selectively removed. A space may then be formed between the sacrificial layer ACL and the lower dielectric layer 110. An etching process that selectively removes the sacrificial layer SL may remove only the sacrificial layer SL, while the active layer ACL remains. For example, only the sacrificial layer SL may be selectively removed, and the remaining active layer ACL may be formed into first channel patterns CH1.

A first gate dielectric layer GI1 may be formed to have a uniform thickness on the first channel patterns CH1. The first gate dielectric layer GI1 may be formed to surround each of the first channel patterns CH1. In addition, the first gate dielectric layer GI1 may cover a top surface of the lower dielectric layer 110.

First gate electrodes GE1 may be formed on the first gate dielectric layer GI1. Each of the first gate electrodes GE1 may include an inner electrode IGE and an outer electrode OGE. For example, the inner electrode IGE may be formed between the first channel patterns CH1 and the lower dielectric layer 110, and the outer electrode OGE may be formed on the first channel patterns CH1.

Then, a planarization process may be performed on the first gate electrodes GE1. Thus, top surfaces of the first gate electrodes GE1 may become substantially coplanar with that a top surface of the interlayer dielectric layer 120.

According to the above, a three-dimensional field effect transistor may be obtained which is formed of the first source/drain pattern SD1, the second source/drain pattern SD2, the first channel pattern CH1, and the first gate electrode GE1.

Referring to FIGS, 11, 12A, 12B, and 12C, mold patterns 125 may be formed on the interlayer dielectric layer 120. The formation of the mold patterns 125 may include forming a mold layer on the interlayer dielectric layer 120, forming mask patterns on the mold layer, and using the mask patterns to pattern the mold layer. The mold patterns 125 may be spaced apart from each other in the second direction D2. The mold patterns 125 may vertically overlap with corresponding first source/drain patterns SD1. The mold patterns 125 may include a material having an etch selectivity with respect to the interlayer dielectric layer 120, but embodiments of the present disclosure are not limited thereto.

Second channel patterns CH2 may be formed on opposite sides of each of the mold patterns 125. The formation of the second channel patterns CH2 may include forming on the top surface 100U of the substrate 100 a channel layer having a uniform thickness covering the mold patterns 125, forming a sacrificial layer and mask patterns on the channel layer, using the mask patterns to pattern the channel layer and the sacrificial layer, and removing the sacrificial layer. The channel layer may be formed by a deposition process, such as one or more from among physical vapor deposition (PVD), thermal chemical deposition process (thermal CVD), low pressure chemical vapor deposition (LPCVD), plasma enhanced chemical vapor deposition (PECVD), and atomic layer deposition (ALD). The sacrificial layer may include a material, for example, having an etch selectivity with respect to the channel layer.

A portion of each of the second channel patterns CH2 may extend onto a lateral surface of the mold pattern 125. A remainder of each of the second channel patterns CH2 may cover the first gate electrode GE1. For example, at least a portion of each of the second channel patterns CH2 may extend in a third direction D3 perpendicular to the top surface 100U of the substrate 100. The second channel patterns CH2 may include, for example, an oxide semiconductor. Thus, the second channel patterns CH2 may be more vulnerable than the first channel patterns CH1 to heat.

For example, a deposition process may form the second channel patterns CH2 on a complicated structure. The deposition process may variously and easily form the second channel patterns CH2 having a uniform thickness. Accordingly, it may be easy to design a semiconductor device.

A second gate dielectric layer GI2 may be formed to have a uniform thickness on the top surface 100U of the substrate 100. The second gate dielectric layer GI2 may cover the mold patterns 125, the second channel patterns CH2, the first gate electrodes GE1, and the interlayer dielectric layer 120. The second gate dielectric layer GI2 may include substantially the same material and thickness as a material and thickness of the first gate dielectric layer GI1, but embodiments of the present disclosure are not limited thereto.

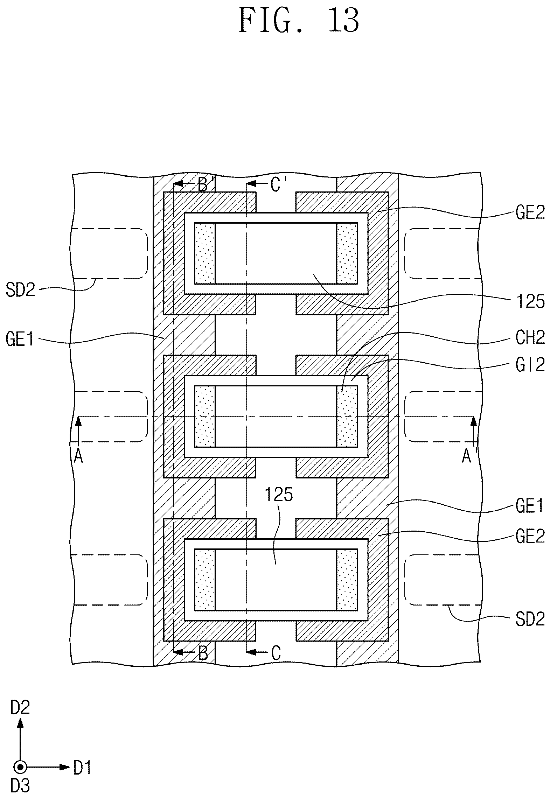

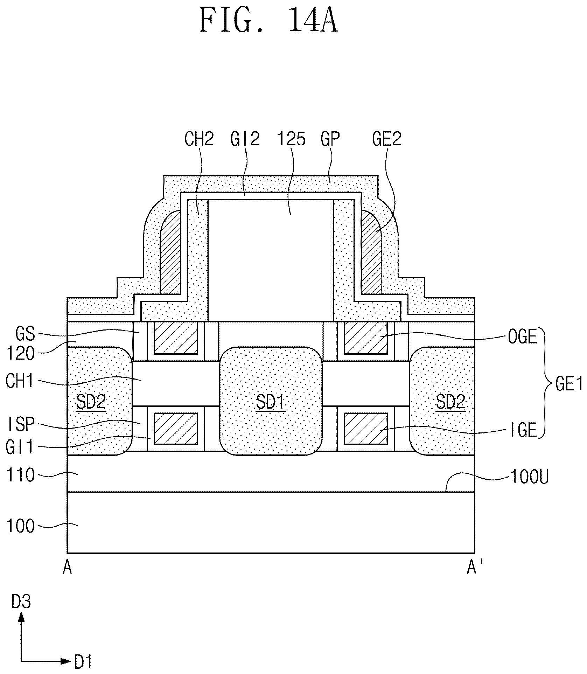

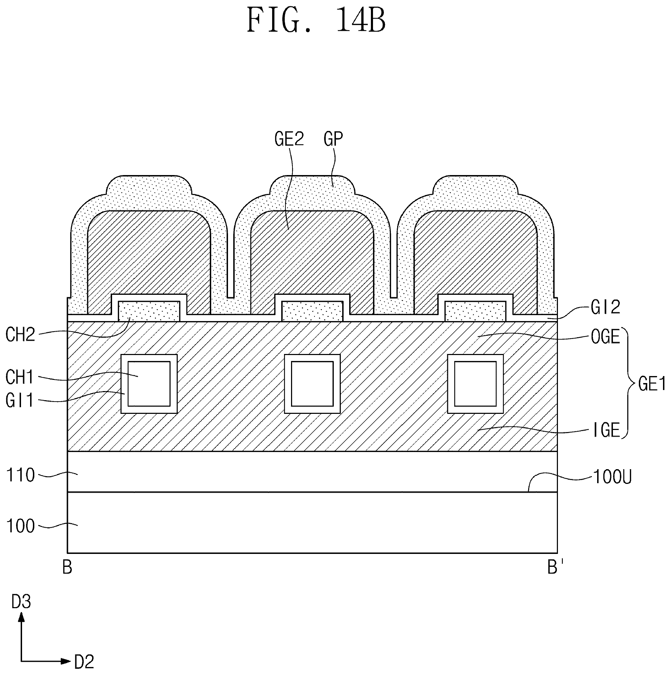

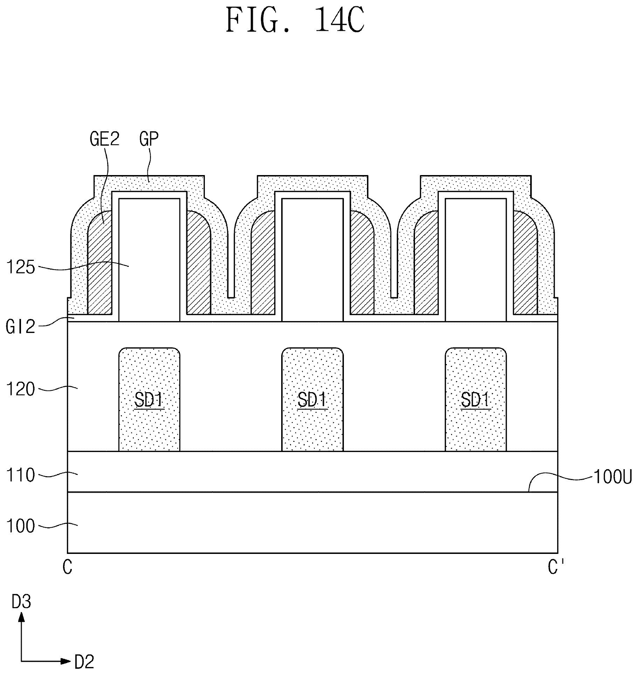

Referring to FIGS. 13, 14A, 14B, and 14C, second gate electrodes GE2 may be formed on the second channel patterns CH2. The formation of the second gate electrodes GE2 may include forming a gate conductive layer on the top surface 100U of the substrate 100 and performing an etching process on the gate conductive layer. A deposition process may be executed to form the gate conductive layer.

The performing of the etching process on the gate conductive layer may include dividing the gate conductive layer into pieces in the first direction D1 across the mold patterns 125. Therefore, the mold pattern 125 may be positioned between the second gate electrodes GE2 that are adjacent to each other in the first direction D1. Each of the second gate electrodes GE2 may have a bracket planar shape (e.g., a shape of a bracket in a plan view, such as, but not limited to, a squared "c" shape), but embodiments of the present disclosure are not limited thereto.

A metal etch-back process may be adopted as the etching process of the gate conductive layer. The metal etch-back process may selectively remove the gate conductive layer including a metallic material. Thus, the second gate dielectric layer GI2 may not be removed. Each of the second gate electrodes GE2 may therefore have a rounded upper portion.

A capping layer GP may be formed on the second gate electrodes GE2. For example, the capping layer GP may be formed by a deposition process. The capping layer GP may cover the second gate electrodes GE2 and the second gate dielectric layer GI2.

As a result, a vertical channel transistor may be obtained which is formed of the second channel pattern CH2 and the second gate electrode GE2.

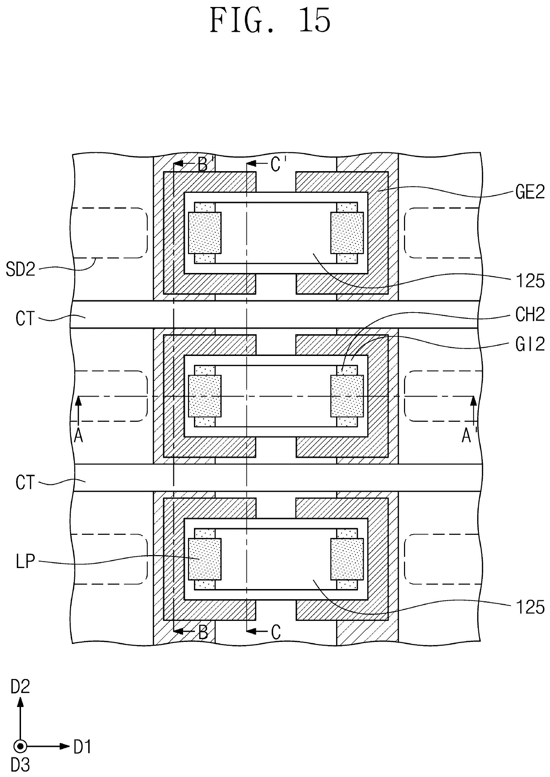

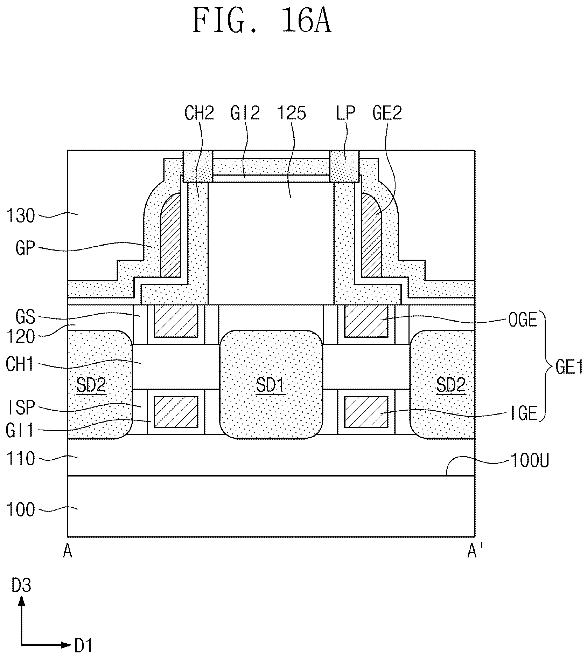

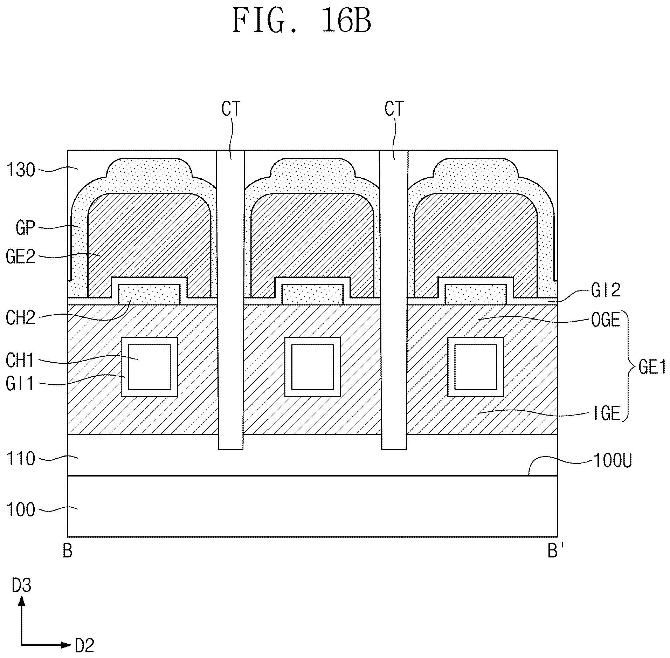

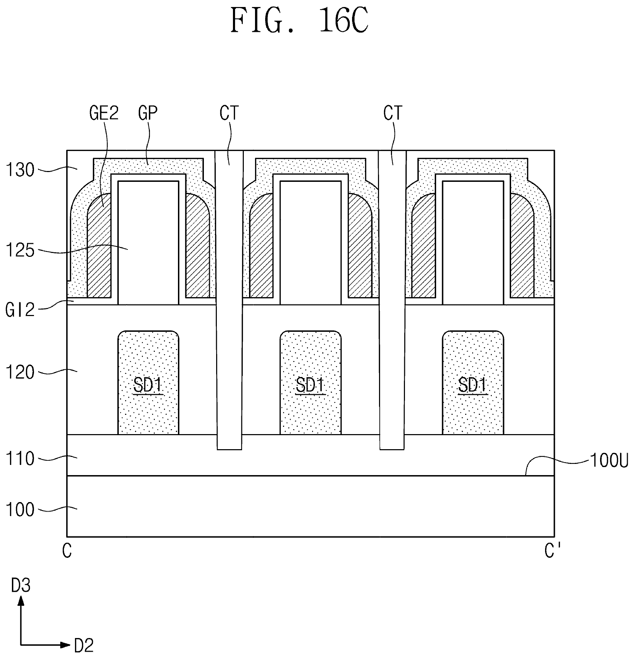

Referring to FIGS. 15, 16A, 16B, and 16C, an upper dielectric layer 130 may be formed on the capping layer GP. The upper dielectric layer 130 may fill a space between the second gate electrodes GE2, while covering the capping layer GP. The upper dielectric layer 130 may have a flat top surface parallel to the first direction D1 and the second direction D2.

Thereafter, landing pads LP may be formed on the second channel patterns CH2. The formation of the landing pads LP may include forming mask patterns on the upper dielectric layer 130, performing an etching process in which the mask patterns are used to expose the second channel patterns CH2, and providing a conductive material on the second channel patterns CH2. The landing pads LP may vertically overlap with corresponding second channel patterns CH2. The landing pads LP may have top surfaces substantially coplanar with a top surface of the upper dielectric layer 130.

Gate cutting patterns CT may be formed to extend across the first gate electrodes GE1. Each of the gate cutting patterns CT may be formed of multiple layers including different dielectric materials. When viewed in a plan view, the gate cutting patterns CT may extend in the first direction D1 and may be spaced apart from each other in the second direction D2. In addition, the gate cutting patterns CT may extend in the third direction D3 from the upper dielectric layer 130 toward the top surface 100U of the substrate 100. Thus, the first gate electrodes GE1 may be electrically separated from each other in the second direction D2.

Referring back to FIGS. 2, 3A, 3B, and 3C, metal layers ML may be formed on the upper dielectric layer 130. The formation of the metal layers ML may include forming a first metal layer ML1, a second metal layer ML2, a third metal layer ML3, and a fourth metal layer ML4 that are sequentially stacked in the third direction D3.

The formation of the first metal layer ML1 may include forming vias VI connected to the landing pads LP, and forming first wiring lines CL1 on the vias VI. The formation of the second metal layer ML2 may include forming gate contacts GC connected to the second gate electrodes GE2, and forming second wiring lines CL2 on the gate contacts GC. The formation of the third metal layer ML3 may include forming second active contacts AC2 connected to the second source/drain patterns SD2, and forming third wiring lines CL3 on the second active contacts AC2. The formation of the fourth metal layer ML4 may include forming first active contacts AC1 connected to the first source/drain patterns SD1, and forming fourth wiring lines CL4 on the first active contacts AC1.

While FIGS. 7-16C show a method of manufacturing a device according to the embodiments of FIGS. 3A-5B, it will be appreciated that a similar methodology may be applied to the formation of a device according to the embodiments of FIGS. 6A and 6B. Instead of depositing a single sacrificial layer SL and active layer ACL, a plurality of sacrificial layers SL and active layers ACL may be alternately deposited. Accordingly, stack patterns STP may be formed to each have a plurality of alternately stacked sacrificial layers SL and the active layers ACL. The remaining manufacturing method may be followed as described above. When the plurality of sacrificial layers SL are removed, the active patterns ACL may form a plurality of semiconductor patterns SP spaced apart in the third direction D3. The first gate electrodes GE1 may be formed to include one or more inner gate electrodes located between adjacent semiconductor patterns SP in the third direction D3.

According to some embodiments of the present disclosure, a method of fabricating a semiconductor device may include forming a three-dimensional field effect transistor including the first channel pattern CH1 and then forming a vertical channel transistor including the second channel pattern CH2. The second channel pattern CH2 relatively vulnerable to heat may be formed subsequently, and thus may be prevented from degradation caused by a subsequent process. As a result, the semiconductor device may have improved electrical properties.

A three-dimensional field effect transistor at a lower position and a vertical channel transistor at an upper position may be electrically connected to each other to constitute a semiconductor device according to some embodiments of the present disclosure. The vertical channel transistor may be used as a write transistor to minimize a leakage current, and the three-dimensional field effect transistor may be used as a read transistor to increase a data retention time. Accordingly, the semiconductor device may have increased integration and improved electrical properties.

In a method of fabricating a semiconductor device according to some embodiments of the present disclosure, the formation of a three-dimensional field effect transistor including a first channel pattern may be followed by the formation of a vertical channel transistor including a second channel pattern. The second channel pattern relatively vulnerable to heat may be formed subsequently, and therefore may be prevented from degradation caused by a subsequent process. As a result, the semiconductor device may improve in electrical properties.

According to some embodiments of the present disclosure, a method of fabricating a semiconductor device may include: forming a stack pattern on a substrate, the stack pattern including a sacrificial layer and an active layer (e.g., including one or more sacrificial layers and active layers that are alternately stacked); forming a first source/drain pattern and a second source/drain pattern in recesses of the stack pattern; forming a first gate electrode and a first channel pattern; forming a mold pattern on the first source/drain pattern; and forming a second channel pattern on the mold pattern, wherein the second channel pattern is formed by a deposition process, and wherein the first channel pattern is formed from the active layer.

According to some embodiments of the present disclosure, the forming the second channel pattern includes allowing the second channel pattern to contact the first gate electrode.

According to some embodiments of the present disclosure, at least a portion of the second channel pattern extends onto a lateral surface of the mold pattern.

According to some embodiments of the present disclosure, the first channel pattern includes silicon, and the second channel pattern includes an oxide semiconductor.

According to some embodiments of the present disclosure, the method may further include forming a gate cutting pattern that extends across the first gate electrode and extends toward the substrate.

According to some embodiments of the present disclosure, the forming the first gate electrode includes: selectively removing the sacrificial layer; and forming the first gate electrode in a space where the sacrificial layer is removed.

Although non-limiting example embodiments of the present disclosure have been described with reference to the accompanying drawings, it will be understood to those skilled in the art that various changes and modifications may be made without departing from the scope of the present disclosure. It therefore will be understood that the example embodiments described above are illustrative and not limitative in all aspects.

Embodiments are set out in the following Clauses:
Clause 1. A semiconductor device, comprising:
   a substrate;
   a first source/drain pattern on the substrate;
   second source/drain patterns on opposite sides of the first source/drain pattern;
   first channel patterns between the first source/drain pattern and the second source/drain patterns;
   first gate electrodes on the first channel patterns;
   second channel patterns on the first gate electrodes;
   a mold pattern between the second channel patterns; and
   second gate electrodes on the second channel patterns,
   wherein the first channel patterns vertically overlap with the second channel patterns, respectively, and
   wherein each of the first channel patterns is connected to the first source/drain pattern.
Clause 2. The semiconductor device of Clause 1, wherein each of the first gate electrodes comprises:
   an inner electrode between the substrate and one of the first channel patterns; and
   an outer electrode on the one of the first channel patterns.
Clause 3. The semiconductor device of Clause 1 or Clause 2, wherein the second channel patterns are in contact with the first gate electrodes, respectively.
Clause 4. The semiconductor device of any of Clauses 1-3, wherein the mold pattern vertically overlaps with the first source/drain pattern.
Clause 5. The semiconductor device of any of Clauses 1-4, wherein each of the second channel patterns comprises:
   a horizontal part that extends parallel to a top surface of the substrate; and
   a vertical part that extends from the horizontal part onto a lateral surface of the mold pattern.
Clause 6. The semiconductor device of Clause 5, wherein, on the horizontal part of one of the second channel patterns, one of the second gate electrodes extends along the vertical part of the one of the second channel patterns.
Clause 7. The semiconductor device of any of Clauses 1-6, wherein
   the first channel patterns comprise silicon, and
   the second channel patterns comprise an oxide semiconductor.
Clause 8. A semiconductor device, comprising:
   a substrate;
   a lower dielectric layer on the substrate;
   first source/drain patterns on the lower dielectric layer;
   second source/drain patterns on opposite sides of at least one of the first source/drain patterns;
   first channel patterns between the first source/drain patterns and the second source/drain patterns;
   first gate electrodes on the first channel patterns;
   gate cutting patterns that penetrate the first gate electrodes;
   second channel patterns on the first gate electrodes; and
   second gate electrodes on the second channel patterns,
   wherein the first gate electrodes are in contact with the second channel patterns, respectively,
   wherein each of the gate cutting patterns extends in a first direction between the first source/drain patterns, and
   wherein each of the first gate electrodes extends in a second direction that crosses the first direction.
Clause 9. The semiconductor device of Clause 8, wherein each of the first source/drain patterns is electrically connected to a pair of adjacent ones of the second source/drain patterns.
Clause 10. The semiconductor device of Clause 8 or Clause 9, wherein
   the first direction and the second direction are parallel to a top surface of the substrate, and
   each of the second channel patterns comprises:
      a horizontal part that extends parallel to the top surface of the substrate; and
      a vertical part that extends, from the horizontal part, in a third direction that crosses the top surface of the substrate.
Clause 11. The semiconductor device of any of Clauses 8-10, wherein
   each of the first gate electrodes is on a top surface, a bottom surface, and lateral surfaces of one of the first channel patterns,
   the first channel patterns comprise silicon, and
   the second channel patterns comprise an oxide semiconductor.
Clause 12. A method of fabricating a semiconductor device, the method comprising:
   forming on a substrate a stack pattern that comprises a sacrificial layer and an active layer;
   recessing the stack pattern to form a first source/drain pattern and a second source/drain pattern;
   forming a first gate electrode and a first channel pattern;
   forming a mold pattern on the first source/drain pattern; and
   forming a second channel pattern on the mold pattern,
   wherein the second channel pattern is formed by a deposition process, and
   wherein the first channel pattern is formed from the active layer.
Clause 13. The method of Clause 12, wherein forming the second channel pattern comprises allowing the second channel pattern to contact the first gate electrode.
Clause 14. The method of Clause 12 or Clause 13, wherein at least a portion of the second channel pattern extends onto a lateral surface of the mold pattern.
Clause 15. The method of any of Clauses 12-14, wherein
   the first channel pattern comprises silicon, and
   the second channel pattern comprises an oxide semiconductor.
Clause 16. The method of any of Clauses 12-15, further comprising a gate cutting pattern that runs across the first gate electrode and extends toward the substrate.
Clause 17. The method of any of Clauses 12-16, wherein forming the first gate electrode comprises:
   selectively removing the sacrificial layer; and
   forming the first gate electrode in a space where the sacrificial layer is removed.

## Claims

1. A semiconductor device, comprising:
a substrate (100);
a first source/drain pattern (SD1) on the substrate (100);
a second source/drain pattern (SD2) on the substrate (100) and spaced apart from the first source/drain pattern (SD1);
a first channel pattern (CH1) between the first source/drain pattern (SD1) and the second source/drain pattern (SD2);
a first gate electrode (GE1) on the first channel pattern (CH1);
a second channel pattern (CH2) on the first gate electrode (GE1); and
a second gate electrode (GE2) on the second channel pattern (CH1),
wherein the second channel pattern (CH2) comprises:
a horizontal part (HP) that extends parallel to a top surface (100U) of the substrate (100); and
a vertical part (VP) that extends, from the horizontal part (HP), in a direction that crosses the top surface (100U) of the substrate (100).

2. The semiconductor device of claim 1, wherein
the first channel pattern (CH1) comprises silicon, and
the second channel pattern (CH2) comprises an oxide semiconductor.

3. The semiconductor device of claim 1 or claim 2, wherein the first gate electrode (GE1) is between the first source/drain pattern (SD1) and the second source/drain pattern (SD2), and surrounds the first channel pattern (CH1).

4. The semiconductor device of any of claims 1-3, wherein the horizontal part (HP) of the second channel pattern (CH2) is in contact with the first gate electrode (GE1).

5. The semiconductor device of any preceding claim, wherein the second gate electrode (GE2) is on a lateral surface of the vertical part (VP) of the second channel pattern (CH2).

6. The semiconductor device of any preceding claim, further comprising wiring lines (CL3, CL4) connected to the first source/drain pattern (SD1) and the second source/drain pattern (SD2),
wherein the wiring lines (CL3, CL4) are on the top surface (100U) of the substrate (100).

7. The semiconductor device of any preceding claim, wherein the first channel pattern (CH1) comprises a first semiconductor pattern (SP1), a second semiconductor pattern (SP2), and a third semiconductor pattern (SP3) that are spaced apart from and stacked on each other.

8. The semiconductor device of claim 7, wherein the first gate electrode (GE1) comprises:
a plurality of inner electrodes (IGE2, IGE3) between the first semiconductor pattern (SP1), the second semiconductor pattern (SP2), and the third semiconductor pattern (SP3); and
an outer electrode (OGE) on the third semiconductor pattern (SP3).

9. The semiconductor device of any preceding claim, further comprising:
a wiring line (CL2) connected to the second gate electrode (GE2); and
a gate contact (GC) between the second gate electrode (GE2) and the wiring line (CL2),
wherein at least a portion of the gate contact (GC) extends into the second gate electrode (GE2).

10. The semiconductor device of any preceding claim, wherein:
the second source/drain pattern (SD2) is one of a plurality of second source/drain patterns (SD2) on opposite sides of the first source/drain pattern (SD1);
the first channel pattern (CH1) is one of a plurality of first channel patterns (CH1) between the first source/drain pattern (SD1) and the second source/drain patterns (SD2);
the first gate electrode (GE1) is one of a plurality of first gate electrodes (GE1) on the first channel patterns (CH1);
the second channel pattern (CH2) is one of a plurality of second channel patterns (CH2) on the first gate electrodes (GE1);
the second gate electrode (GE2) is one of a plurality of second gate electrodes (GE2) on the second channel patterns (CH2),
the semiconductor device further comprises a mold pattern (125) between the second channel patterns (CH2);
the first channel patterns (CH1) vertically overlap with the second channel patterns (CH2), respectively, and
each of the first channel patterns (CH1) is connected to the first source/drain pattern (SD1).

11. The semiconductor device of claim 10, wherein each of the first gate electrodes (GE1) comprises:
an inner electrode (IGE) between the substrate (100) and one of the first channel patterns (CH1); and
an outer electrode (OGE) on the one of the first channel patterns (CH1).

12. The semiconductor device of claim 10 or claim 11, wherein the second channel patterns (CH2) are in contact with the first gate electrodes (GE1), respectively.

13. The semiconductor device of any of claims 10-12, wherein the mold pattern (125) vertically overlaps with the first source/drain pattern (SD1).

14. The semiconductor device of any of claims 10-13, wherein each of the second channel patterns (CH2) comprises:
a horizontal part (HP) that extends parallel to the top surface (100U) of the substrate (100); and
a vertical part (VP) that extends from the horizontal part (HP) onto a lateral surface of the mold pattern (125).

15. The semiconductor device of claim 14, wherein, on the horizontal part (HP) of one of the second channel patterns (CH2), one of the second gate electrodes (GE2) extends along the vertical part (VP) of the one of the second channel patterns (CH2).
